# EUROPÄISCHE PATENTANMELDUNG

(11) **EP 2 395 664 A1**
(43) Veröffentlichungstag der Anmeldung: **14.12.2011**
(21) Anmeldenummer: 11151009.5
(22) Anmeldetag: 14.01.2011
(51) Int. Cl.: H03K 7/08

(54) **Verfahren und Vorrichtung zur Phasen- und /oder Pulsweitenmodulation**

(30) Priorität: 14.06.2010 DE 102010030031
(71) Anmelder: IHP GmbH-Innovations for High Performance Microelectronics / Leibniz-Institut für innovative Mikroelektronik, 15236 Frankfurt / Oder (DE)
(72) Erfinder: Scheytt, Johann Chritstoph, 15234 Frankfurt (Oder) (DE)
(74) Vertreter: Eisenführ, Speiser & Partner

(57) **Zusammenfassung**

Die vorliegende Erfindung betrifft eine Vorrichtung (2000) sowie ein Verfahren zum Kodieren eines Eingangssignals (102) in ein digitales pulsweiten- und/oder phasenmoduliertes Ausgangssignal (162). Außerdem betrifft die vorliegende Erfindung ein Sendeverfahren, einen Leistungsverstärker und einen Sender. Mit Hilfe eines wenigstens dreistufigen Abbildungsprozesses wird eine Folge von Ausgangsimpulsen (162) erzeugt, die im zeitlichen Mittel einem zuvor berechneten theoretischen Zielimpuls entspricht. Auf diese Weise kann die Vorrichtung (2000) beziehungsweise das Verfahren vollständig digital implementiert sein/werden und zudem ein Großteil (100, 110) der Vorrichtung (2000) bei einer Taktrate betrieben werden, die wesentlich geringer ist als eine Taktrate des Ausgangssignalgenerators (200, 220).

## Beschreibung

Die Erfindung betrifft zum einen ein digitales Modulationsverfahren, das eine Phasenmodulation oder eine Pulsweitenmodulation oder eine kombinierte Phasen- und Pulsweitenmodulation realisiert. Zudem wird eine digitale Modulationsvorrichtung vorgeschlagen, die sich zur Implementierung des Modulationsverfahrens eignet. Das Verfahren und die Vorrichtung eignen sich insbesondere für Hochfrequenz (HF)-Anwendungen. Außerdem betrifft die vorliegende Erfindung einen Leistungsverstärker, eine Sendevorrichtung sowie ein Sendeverfahren.

### Stand der Technik

Ein Modulationsverfahren wird eingesetzt, um ein Signal zum Zwecke einer drahtgebundenen oder drahtlosen Übertragung zu kodieren. Grundsätzlich sind Verfahren dieser Art bekannt.

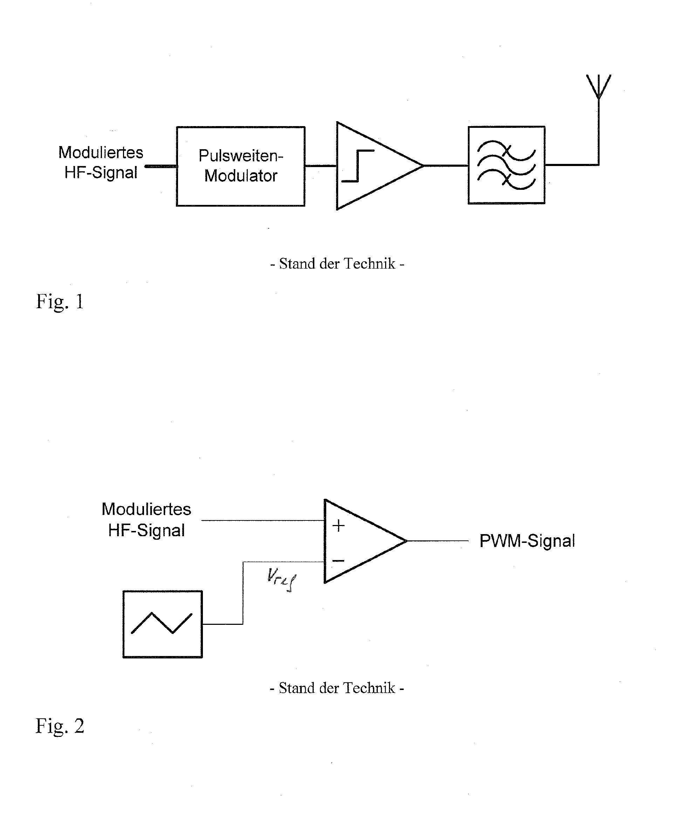

Beispielsweise zeigt Figur 1 einen HF Klasse-D-Leistungsverstärker nach dem Stand der Technik. Ein HF-Signal, das in Amplitude und Phase moduliert ist, wird dem Eingang eines Pulsweitenmodulators gegeben, der das Signal in ein pulsweiten- und phasenmoduliertes Signal (PWM-Signal) kodiert. Der nachgeschaltete Leistungsverstärker verstärkt das PWM-Signal. Aufgrund der binären Signalform kann der Leistungsverstärker als nichtlinearer Schaltverstärker ausgelegt werden, der typischerweise eine hohe Energieeffizienz aufweist. Am Ausgang des Leistungsverstärkers wird das verstärkte PWM-Signal bandpassgefiltert, wodurch harmonische Frequenzanteile unterdrückt werden und nur das verstärkte modulierte HF-Signal zur Antenne geleitet wird.

Figur 2 zeigt eine typische Implementierung eines Pulsweitenmodulators nach dem Stand der Technik. Ein Rampengenerator erzeugt eine periodenförmige, dreieckförmige Spannung *V*ref(*t*). Das amplituden- und phasenmodulierte HF-Signal und *V*_{ref} werden auf einen schnellen Komparator gegeben. Durch den Vergleich der Rampe mit dem HF-Signal wird ein pulsweiten- und phasenmoduliertes Signal erzeugt.

Der Pulsweitenmodulator nach Figur 2 hat den Vorteil der einfachen Implementierung. Jedoch hat er verschiedene gravierende Nachteile. Zum einen ist die Linearität des Modulators, d.h. die Genauigkeit mit der Phase und Amplitude des HF-Signals in das PWM-Signal umgesetzt wird, von der Genauigkeit der Rampe abhängig. Im GHz-Bereich ist eine hochgenaue lineare Rampe kaum zu erzeugen, insbesondere die "Spitzen" des Dreiecksignals sind aufgrund endlicher Bandbreite der elektronischen Bauelemente mehr oder weniger stark abgerundet, so dass sich mit zunehmender Frequenz ein eher sinusförmiger statt dreieckförmiger Verlauf ausbildet. Dadurch ergibt sich eine nichtlineare Verzerrung von Phase und Amplitude im Modulator. Des Weiteren schaltet der Komparator mehr oder weniger schnell in Abhängigkeit von vorherigen Schaltvorgängen, da bei hohen Schaltfrequenzen die inneren Strom-/Spannungs-Ausgleichsvorgänge des Komparators nicht vollständig abgeklungen sind. Durch diese Eigenschaft des Komparators weist das PWM-Signal eine zusätzliche zeitliche Unsicherheit (Jitter) auf, die als Phasen-und Amplituden-Rauschen interpretiert werden kann.

Ein weiterer Nachteil des Pulsweitenmodulators nach Figur 2 ist, dass sehr kleine und sehr große Pulsweiten, die vom Modulator erzeugt werden, bewirken können, dass der Leistungsverstärker nicht voll durchschaltet, wodurch wiederum nichtlineare Verzerrungen von Phase und Amplitude auftreten. Ein weiterer Nachteil dieses Modulators ist, dass Phase und Amplitude nicht unabhängig voneinander moduliert werden können, so dass amplituden- oder phasenspezifische Verzerrungen nicht getrennt kompensiert werden können. Ein weiterer Nachteil des Modulators ist, dass er eine analoge Schaltung darstellt, die stark von Prozess-, Spannungs- und Temperaturschwankungen beeinflusst ist. Ein weiterer Nachteil ist, dass als eingangsseitig ein HF-Signal benötigt wird.

In Frederick H. Raab: "Radio Frequency Pulse Width Modulation", Transactions on Communications, Aug. 1973, pp. 958-959 wird ein Rampengenerator beschrieben, bei dem die Vergleichsspannung *V*_{ref} mittels Gleichrichtung des modulierten HF-Signals erzeugt wird. Auch hier ergibt sich bei hohen Frequenzen im GHz-Bereich die Schwierigkeit, das Vergleichssignal *V*_{ref}(*t*) mit hoher Genauigkeit zu erzeugen. Insbesondere weist das gleichgerichtete Signal nahe des Nulldurchgangs einen dreieckförmigen Verlauf auf, der durch die begrenzte Bandbreite der elektronischen Schaltung abgerundet und damit verzerrt wird.

Aus der Veröffentlichung J. Keyzer et al.: "Generation of RF Pulsewidth Modulated Microwave Signals Using Delta-Sigma Modulation", 2002, IEEE MTT-S Digest, Seiten 397-400, sind ein Verfahren und eine Schaltung zur Pulsweitenmodulation bekannt. Dort kommen bei der Pulsweitenmodulation anstelle eines einfachen Komparators, wie in Fig. 2 gezeigt, zwei Delta-Sigma-Modulatoren zum Einsatz. Ein zu kodierendes Signal ist dort durch einen Phasensignalanteil und einen Amplitudensignalanteil repräsentiert. Der Phasensignalanteil ist einem ersten Delta-Sigma-Modulator zugeführt und der Amplitudensignalanteil einem zweiten Delta-Sigma-Modulator zugeführt. Das Ausgangssignal des ersten Delta-Sigma-Modulators sowie ein Ausgangssignal eines Pulsgenerators steuern einen sogenannten digitalen Pulsverzögerungsmodulator. Dessen Ausgangssignal ist zusammen mit dem Ausgangssignal des zweiten Delta-Sigma-Modulators einem digitalen Pulsweitenmodulator zugeführt, der das pulsweiten- und amplitudenmodulierte Ausgangssignal erzeugt. Bei dem aus dieser Veröffentlichung bekannten Verfahren wird zunächst die Phase moduliert und sodann die Amplitude, also die Pulsweite eines Impulses im Ausgangssignal. Im Ergebnis ist die aus dieser Veröffentlichung bekannte Schaltung aufwendig, da zum einen wenigstens zwei Delta-Sigma-Modulatoren zum Einsatz kommen und zum anderen sowohl der Pulsverzögerungsmodulator und der Pulsweitenmodulator in etwa bei der Frequenz des Ausgangssignals operieren müssen. Hinzu kommt, dass das Ausgangssignal bei einem derartigen Pulsverzögerungsmodulator und einem derartigen Pulsweitenmodulator im Falle einer analogen Implementierung im Hochfrequenzbereich Verzerrungen aufweist.

### Zusammenfassung der Erfindung

Es ist eine der vorliegenden Erfindung zugrundeliegende technische Aufgabe, eine verbesserte Vorrichtung und ein verbessertes Verfahren zum Kodieren eines Eingangssignals in ein digitales pulsweiten- und/oder phasenmoduliertes Ausgangssignal vorzuschlagen, die bzw. das sich für Hochfrequenzanwendungen eignet und mit vergleichsweise wenig Aufwand realisierbar bzw. ausführbar ist.

Gemäß einem ersten Aspekt der vorliegenden Erfindung wird die technische Aufgabe gelöst durch eine Vorrichtung zum Kodieren eines Eingangssignals in ein digitales pulsweiten- und/oder phasenmoduliertes Ausgangssignal, im Folgenden als digitales Ausgangssignal bezeichnet, die folgende Komponenten umfasst:
- einen Eingang zum Empfangen des Eingangssignals und einen Ausgang zum Ausgeben des digitalen Ausgangssignals,
- einen Phasenkodierer, der ausgebildet ist, aus dem Eingangssignal ein binäres erstes Startphasenwort und eines binäres erstes Endphasenwort mit einer ersten Auflösung abzuleiten, wobei
- das erste Startphasenwort einen Startzeitpunkt innerhalb einer Periode bestimmt, zu dem eine steigende Flanke eines Zielimpulses im digitalen Ausgangssignal auftreten soll, und das erste Endphasenwort einen Endzeitpunkt innerhalb der Periode bestimmt, zu dem eine fallende Flanke des Zielimpulses im digitalen Ausgangssignal auftreten soll,
- einen Phaseninterpolator, der dem Phasenkodier nachgeschaltet ist und ausgebildet ist, mit einer zweiten Auflösung, die kleiner als die erste Auflösung ist, das erste Startphasenwort in eine Vielzahl zweiter binärer Startphasenwörter und das erste Endphasenwort in eine Vielzahl zweiter binärer Endphasenwörter umzuwandeln, wobei
- ein jeweiliges zweites Startphasenwort einen von N möglichen diskreten Zeitpunkten in der Periode beschreibt und damit den Startzeitpunkt mit der zweiten Auflösung annähernd bestimmt und ein jeweiliges zweites Endphasenwort einen der N möglichen diskreten Zeitpunkte in der Periode beschreibt und damit den Endzeitpunkt mit der zweiten Auflösung annähernd bestimmt, und
- einen Ausgangssignalgenerator, der ausgebildet ist, die Vielzahl zweiter Startphasenwörter und die Vielzahl zweiter Endphasenwörter in eine serielle Folge von Ausgangsimpulsen umzusetzen und als Ausgangssignal über den Ausgang auszugeben, wobei die serielle Folge von Ausgangsimpulsen im zeitlichen Mittel dem Zielimpuls entspricht.

Die erfindungsgemäße Vorrichtung hat den Vorteil, dass sie nahezu vollständig mit digitalen Schaltungskomponenten realisiert werden kann. Es kommen keine analogen Geräte wie Mischer, Rampengeneratoren oder andere nicht getaktete Komponenten zum Einsatz, so dass Nachteile, die derartige Komponenten gewöhnlicher Weise mit sich bringen, vermieden werden. So ist die Vorrichtung in ihrer Struktur einfacher und in der Funktion sicherer und zuverlässiger als vorbekannte Vorrichtungen. Insbesondere ist die Vorrichtung resistent gegen Schwankungen sogenannter PVT-Werte. PVT steht für "Porcess-Voltage-Temperature", wobei mit Process"-Werten Werte technologisch hervorgerufener Parameter wie eine Bauteilabmessung oder eine Materialreinheit gemeint sind, mit Voltage" beispielsweise eine Versorgungsspannung und mit "Temperature" beispielsweise eine Betriebs- oder Umgebungstemperatur. Der Phasenkodierer, der Phaseninterpolator und der Ausgangssignalgenerator können jeweils quarzgenau getaktet sein.

Die Vorrichtung hat den weiteren Vorteil, dass erst der Ausgangssignalgenerator bei einer für das digitale Ausgangssignal notwendigen hohen Ausgangssignalgeneratortaktrate betrieben werden muss. Der dem Ausgangssignalgenerator vorgeschaltete Phasenkodierer und Phaseninterpolator hingegen können bei einer wesentlich niedrigeren Phasenkodierer- bzw. Phaseninterpolatortaktrate betrieben werden, wobei das Verhältnis von diesen Taktraten und der Ausgangssignalgeneratortaktrate im Wesentlichen durch den Betrag der Vielzahl zweiter Startphasenwörter bzw. zweiter Endphasenwörter bestimmt ist, was weiter unten ausführlicher erläutert ist. Beispielsweise liegt der Betrag der Vielzahl bei M = 20 und die Ausgangssignalgeneratortaktrate bei 2 GHz. Phasenkodierer und Phaseninterpolator können dann beispielsweise bei jeweils 100 MHz betrieben werden. Aufgrund der vergleichsweisen niedrigen Phasenkodierer- bzw. Phaseninterpolatortaktrate haben der Phasenkodierer und der Phaseninterpolator jeweils einen vergleichsweise geringen Energiebedarf, was grundsätzlich positiv ist. Beispielsweise können Kühlvorrichtungen für die Vorrichtung, die grundsätzlich vergleichsweise teuer, schwer sowie voluminös sind, aufgrund des niedrigen Energiebedarfs klein dimensioniert werden.

Ein anderer Vorteil der Vorrichtung ist, dass sie sich für eine Vielzahl verschiedener Frequenzbereiche, beispielsweise für eine Vielzahl verschiedener Sendefrequenzen eignet. Somit kann dieselbe Vorrichtung für verschiedene Funkstandards zum Einsatz kommen bzw. eine Vielzahl verschiedener Funkbänder mit derselben Vorrichtung bedient werden. Allenfalls muss eine Filterfrequenz eines dem Ausgangssignalgenerator optional nachschaltbaren Rekonstruktionsfilters angepasst werden.

Ein weiterer Vorteil der Vorrichtung ist, dass als Eingangssignal nicht notwendigerweise ein zu kodierendes HF-Signal selbst benötigt wird, sondern nur ein diesem entsprechendes digitales Basisbandsignal, das eine Amplitude und/oder eine Phase repräsentiert.

Die erfindungsgemäße Vorrichtung ist ausgebildet, das Eingangssignal in wenigstens drei Stufen in das digitale Ausgangssignal zu kodieren, wobei die erste Stufe eine Abbildung des Eingangssignals auf ein hochaufgelöstes erstes Startphasenwort und ein hochaufgelöstes erstes Endphasenwort ist und die zweite Stufe eine Abbildung dieser beiden Wörter auf die Vielzahl zweiter, niedriger aufgelöster Startphasenwörter und Endphasenwörter. Die dritte Stufe ist die physikalische Umsetzung der Vielzahl zweiter Start- und Endphasenwörter in die serielle Impulsfolge, die das digitale Ausgangssignal bildet. Dieser Abbildungsprozess bewirkt keinen Informationsverlust. Vielmehr werden die ersten Phasenwörter einer ersten Länge auf M zweite Phasenwörter einer zweiten Länge ohne Informationsverlust abgebildet, wobei die zweiten Phasenwörter an den Ausgangssignalgenerator übergeben werden, bevorzugt sequentiell.

Die erfindungsgemäße Vorrichtung realisiert eine Phasenmodulation oder eine Pulsweitenmodulation oder eine kombinierte Phasen- und Pulsweitenmodulation. Die Vorrichtung ist demnach ausgebildet, Phase und Amplitude unabhängig voneinander zu modulieren. So können amplituden- oder phasenspezifische Verzerrungen eines dem Ausgangssignalgenerator optional nachschaltbaren Leistungsverstärkers getrennt kompensiert werden.

Beispielsweise beträgt die Frequenz des Eingangssignals 5 MHz. Sie kann mit einer Basisband-Datenrate übereinstimmen. Die Taktrate des Phasenkodierers kann mit der Frequenz des Eingangssignals übereinstimmen und 5 MHz betragen. Die Länge der Kodierperiode beträgt demnach in diesem Beispiel 200 ns. Die erste Auflösung, mit der der Phasenkodierer das Ableiten vornimmt, beträgt beispielsweise 12 Bit. Die Taktrate des Phaseninterpolators liegt beispielsweise zwischen 5 MHz und 2 GHz und die zweite Auflösung, mit der der Phaseninterpolator das Umwandeln vornimmt, bei 4 Bit. Die Taktrate, mit der der Ausgangssignalgenerator das Umsetzen vornimmt, liegt bei beispielsweise 2 GHz. Die Vielzahl zweiter Startphasenwörter und die Vielzahl zweiter Endphasenwörter ergibt sich beispielsweise aus dem Verhältnis der Taktraten von Phasenkodierer und Ausgangssignalgenerator, liegen also beispielsweise jeweils bei 400 Stück (2 GHz dividiert durch 5 MHz). Die Frequenz des Ausgangssignals kann mit der Taktrate des Ausgangssignalgenerators übereinstimmen, also 2 GHz betragen. Die vorstehend angegebenen Zahlenwerte sind beispielsweise dann maßgeblich, wenn die erfindungsgemäße Vorrichtung im UMTS Bereich eingesetzt wird.

Im Rahmen der Beschreibung der vorliegenden Erfindung meint der Begriff "Eingangssignal" das in das digitale Ausgangssignal zu kodierende Eingangssignal. Entsprechend wird auch von einem "zu kodierenden Eingangssignal" gesprochen. Wie weiter unten detaillierter ausgeführt ist, kann das zu kodierende Eingangssignal auch als Basisbandsignal vorliegen, das eine Amplitude und/oder eine Phase repräsentiert, also lediglich den Modulationsgehalt ohne Trägersignal. Dementsprechend wird auch von einem "Basisbandsignal" statt von einem "Eingangssignal" gesprochen.

Bei dem digitalen Ausgangssignal handelt sich um eine Folge von Ausgangsimpulsen, die jeweils in Phase und/oder in Pulsweite moduliert sind. Das Ausgangssignal hat demnach zu einem gegebenen Zeitpunkt entweder den Wert einer logischen Null oder einer logischen Eins.

Das Phasenkodierer ist ausgebildet, aus dem Eingangssignal das erste Startphasenwort und das erste Endphasenwort mit der ersten Auflösung abzuleiten. Im Rahmen der Beschreibung der vorliegenden Erfindung meint der Begriff "Auflösung" eine Genauigkeit einer Zeitangabe. Beispielsweise bestimmt der Phasenkodierer den Startzeitpunkt des Zielimpulses mit einem 8 Bit breiten ersten Startphasenwort. Die erste Auflösung beträgt in diesem Beispiel also a = 8 Bit. Somit können insgesamt A = 256 Zeitpunkte der Periode bestimmt werden. Das erste Startphasenwort und das erste Endphasenwort können demnach jeweils als Zahlenwert verstanden werden.

Im Rahmen der Beschreibung der vorliegenden Erfindung meint Kodierperiode eine periodisch wiederkehrende Zeitspanne, in der jeweils ein Zielimpuls liegt. Der Phasenkodierer ist ausgebildet, im Eingangssignal enthaltene Information, wie beispielsweise die aktuelle Amplitude und/oder die aktuelle Phasenlage, durch Definieren der Lage und Pulsweite des Zielimpulses in der Kodierperiode abzubilden.

Der Phasenkodierer kann beispielsweise einen Speicher in Gestalt einer Look-Up Tabelle beinhalten, bei der die Gesamtheit der in einer Taktperiode des Eingangssignals darstellbaren Information bereits tabellarisch ersten Startphasenwörter und ersten Endphasenwörter zugeordnet ist. Alternativ kann der Phasenkodierer auch formelbasiert arbeiten und über eine kleinere Recheneinheit verfügen.

Der Zielimpuls hat demnach eine bestimmte Zielphasenlagen und/oder eine bestimmte Zielpulsweite. Sowohl die Zielphasenlage als auch die Zielpulsweit sind durch den Startzeitpunkt und den Endzeitpunkt festgelegt.

Die zweite Auflösung ist geringer als die erste Auflösung und liegt beispielsweise bei n = 6 Bit. Im Sinne der obigen Ausführung beschreiben ein jeweiliges der Vielzahl zweiter Startphasenwörter und ein jeweiliges der Vielzahl zweiter Endphasenwörter dann jeweils einen von N = 64 Zeitpunkten der Kodierperiode und können ebenfalls als Zahlenwerte verstanden werden. Beispielsweise ist der Zahlenwert des ersten Startphasenwortes 9,5. Dann betragen beispielsweise ein Zahlenwert eines zweiten Startphasenwortes 9 und der Zahlenwert eines anderen zweiten Startphasenwortes 10.

Der Phaseninterpolator ist ausgebildet, die Vielzahl zweiter Startphasenwörter und die Vielzahl zweiter Endphasenwörter derart zu erzeugen, dass sich diese zur Interpolation des Startzeitpunktes bzw. des Endzeitpunktes eignen. Im Sinne der vorliegenden Erfindung bedeutet eine geringere/niedrigere Auflösung demnach eine schlechtere Auflösung.

Der Ausgangssignalgenerator ist ausgebildet, die Vielzahl zweiter Startphasenwörter und die Vielzahl zweiter Endphasenwörter, die man jeweils auch als ein Bündel von Zahlenwerten verstehen kann, in die serielle Folge von Ausgangsimpulsen umzusetzen. Durch die Umsetzung vervielfacht sich die Datenrate. Eine Ausgangssignalperiode der Folge von Ausgangsimpulsen ist demnach um ein Vielfaches kürzer als die Kodierperiode, wobei das Verhältnis von Kodierperiode und Ausgangssignalperiode im Wesentlichen durch den Betrag der Vielzahl zweiter Start- bzw. Endphasenwörter bestimmt ist, wie weiter unten ausführlich erläutert ist.

Bevorzugt ist der Phaseninterpolator ausgebildet, die Vielzahl zweiter Startphasenwörter und die Vielzahl zweiter Endphasenwörter jeweils in Gestalt eines Vektors zu erzeugen. Dabei kommt bevorzugt eine parallele Umsetzung zum Einsatz, so dass die Vielzahl zweiter Startphasenwörter und die Vielzahl zweiter Endphasenwörter jeweils in etwa zeitgleich vom Phaseninterpolator bereitgestellt sind.

Bevorzugt ist dem Ausgangssignalgenerator ein Rekonstruktionsfilter nachgeschaltet, das ausgebildet ist, das digitale Ausgangssignal zu filtern und ein gefiltertes Ausgangssignal auszugeben. Das Rekonstruktionsfilter kann ein Bandpassfilter sein und als ein solches Signalanteile aus dem digitalen Ausgangssignal dämpfen, deren Frequenzen oberhalb einer Obergrenze oder unterhalb einer Untergrenze liegen. Das Rekonstruktionsfilter ist beispielsweise ein passives Bandpassfilter oder ein passives Tiefpassfilter. Das Rekonstruktionsfilter kann auch ein sogenanntes Cavity-Filter sein, welches auf Hohlraumresonatoren basiert. Das Rekonstruktionsfilter hat im Wesentlichen die Aufgabe, unerwünschte Signalanteile zu unterdrücken. Bevorzugt hat das Rekonstruktionsfilter keine bis geringe Wirkleistungsverluste.

Nachfolgend werden weitere bevorzugte Ausführungsbeispiele der Vorrichtung des ersten Aspektes der vorliegenden Erfindung beschrieben. Die zusätzlichen Merkmale dieser weiteren bevorzugten Ausführungsbeispiele können zum Bilden anderer Ausführungsformen miteinander und/oder mit den oben bereits genannten optionalen Merkmalen kombiniert werden, sofern sie nicht ausdrücklich als alternativ zueinander beschrieben sind.

In einer besonders bevorzugten Ausführungsform ist dem Ausgangssignalgenerator ein Referenztaktsignal zugeführt. In dieser Ausführungsform weist der Ausgangssignalgenerator auf:
- einen Multiphasentaktsignalgenerator, der ausgebildet ist, aus dem Referenztaktsignal ein Multiphasentaktsignal abzuleiten, das eine Vielzahl um diskrete Phasenbeträge phasenverschobener Taktsignale aufweist, deren Phasenverschiebung gegenüber dem Referenztaktsignal sich beginnend mit Null von einem Taktsignal zum nächsten jeweils um einen Phasenabstand erhöht,
- einen Startphasenmultiplexer und einen Endphasenmultiplexer, denen jeweils das Multiphasentaktsignal eingangsseitig zugeführt ist, wobei
- der Startphasenmultiplexer ausgebildet ist, in Abhängigkeit der Vielzahl zweiter Startphasenwörter eines der phasenverschobenen Taktsignale als Startphasensignal auf seinen Ausgang durchzuschalten und
- der Endphasenmultiplexer ausgebildet ist, in Abhängigkeit der Vielzahl zweiter Endphasenwörter eines der phasenverschobenen Taktsignale als Endphasensignal auf seinen Ausgang durchzuschalten, und
- einen Signalkombinierer, der ausgebildet ist, das Startphasensignal und das Endphasensignal zum digitalen Ausgangssignal zusammenzuführen, indem
- das Startphasensignal die steigende Flanke eines jeweiligen Ausgangsimpulses im Ausgangssignal auslöst und das Endphasensignal die fallende Flanke des jeweiligen Ausgangsimpulses auslöst.

Diese Ausführungsform hat den Vorteil, dass die die Genauigkeit der Vorrichtung, d.h. die Genauigkeit, mit der das Eingangssignal in das pulsweiten- und/oder phasenmodulierte digitale Ausgangssignal kodiert wird, vor allem über eine hohe Genauigkeit des Multiphasentaktsignalgenerators erzielt werden kann, d.h. über ein Multiphasentaktsignal, dessen phasenverschobene Taktsignale jeweils sehr zeitgenaue steigende und fallende Flanken aufweisen. Von der Genauigkeit der übrigen Schaltungskomponenten ist das digitale Ausgangssignal in dieser Ausführungsform weitestgehend unabhängig, da die Vorrichtung vom Eingangssignal gesteuert ist, aber nicht das Eingangssignal, sondern das genaue Multiphasentaktsignal in das digitale Ausgangssignal transformiert.

Ein weiterer Vorteil dieser Ausführungsform ist, dass Phase und Amplitude unabhängig voneinander moduliert werden können, so dass amplituden- oder phasenspezifische Verzerrungen eines dem Ausgangssignalgenerator optional nachschaltbaren Leistungsverstärkers getrennt kompensiert werden können.

Ein anderer Vorteil dieser Ausführungsform ist, dass der Multiphasentaktsignalgenerator, wie die meisten übrigen Schaltungskomponenten der Vorrichtung auch, digital implementiert werden kann, und somit weitestgehend unabhängig von Schwankungen der PVT-Werte ist. Eine digitale Implementierung des Multiphasentaktgenerators ist also gegenüber einer ebenfalls möglichen analogen Implementierung bevorzugt.

Der Multiphasentaktsignalgenerator umfasst zum Erzeugen eines genauen Multiphasentaktsignals beispielsweise einen sogenannten Delay-Locked-Loop in Gestalt einer integrierten Schaltung. Bis auf eine mögliche Phasenungenauigkeit einzelner Taktsignale des Multiphasentaktsignals zeigt das erzeugte digitale Ausgangssignal keine zusätzliche zeitliche Unsicherheit (Jitter).

In einer Ausführungsform erzeugt der Multiphasentaktsignalgenerator beispielsweise ein Multiphasentaktsignal mit N zueinander phasenverschobener Taktsignalen. In dieser Ausführungsform sind dem Startphasenmultiplexer und dem Endphasenmultiplexer jeweils eines der Vielzahl zweiter Startphasenwörter bzw. Endphasenwörter als jeweiliges Steuersignal zugeführt, die jeweils wenigstens Id(N) Bit breit sind.

In der Ausführungsform mit dem Multiphasentaktsignalgenerator ist zusätzlich bevorzugte, das der Ausgangssignalgenerator eine Synchronisationsschaltung umfasst, der eingangsseitig das Startphasensignal und das Endphasensignal zugeführt sind und die ausgebildet ist, in Abhängigkeit des Startphasensignals und des Endphasensignals die Vielzahl zweiter Startphasenwörter und die Vielzahl zweiter Endphasenwörter in ein Startphasenauswahlsignal und ein Endphasenauswahlsignal zu transformieren und das Startphasenauswahlsignal dem Startphasenmultiplexer als Steuersignal zuzuführen und das Endphasenauswahlsignal dem Endphasenmultiplexer als Steuersignal zuzuführen.

Durch die dargestellte Rückkopplung des Startphasensignals und des Endphasensignals ist in vorteilhafter Weise sichergestellt, dass die Startphasenmultiplexer nicht während einer fallenden Flanke und der Endphasenmultiplexer nicht während einer steigenden Flanke umgeschaltet werden.

Bei der obigen Ausführungsform der Vorrichtung mit dem Multiphasentaktsignalgenerator schaltet der Ausgangssignalgenerator gemäß einem Interpolationsverfahren demnach gezielt zwischen diskreten Phasenwerten, d.h. Taktsignalen, um, so dass sich im Mittel der Zielimpuls ergibt. Die Phaseninterpolation ist z.B. mittels eines Delta-Sigma-Modulators implementiert. Beispielsweise beinhaltet der Phaseninterpolator in dieser Ausführungsform einen ersten und einen zweiten Delta-Sigma-Modulator, wobei der erste Delta-Sigma-Modulator das erste Startphasenwort empfängt und die Vielzahl zweiter Startphasenwörter ausgibt und der zweite Delta-Sigma-Modulator das erste Endphasenwort empfängt und die Vielzahl zweiter Endphasenwörter ausgibt.

Zur Mittelung der Phasensprünge ist bevorzugt ein dem Ausgangssignalgenerator nachgeschaltetes Rekonstruktionsfilter vorgesehen.

Die Frequenz des Referenztaktsignals stimmt in einer Ausführungsform im Wesentlichen mit der Frequenz des digitalen Ausgangssignals überein. Die Frequenz des Referenztakts kann auch leicht abweichen. Dann müsste die Frequenzabweichung durch kontinuierliche Phasennachstellung kompensiert werden. Dies hätte den Vorteil, dass einzelne ungenaue Phasen des Multiphasentaktsignals sich im digitalen Ausgangssignal ausmitteln würden und begrenzten Einfluss hätten.

Ein einphasiges Referenztaktsignal ist bevorzugt.

Der Signalkombinierer ist beispielsweise ein RS-Flipflop, dem beispielsweise das Startphasensignal über seinen S-Eingang und das Endphasensignal über seinen R-Eingang zugeführt sind. Ein Signal, das den Zustand des RS-Flipflops angibt, bildet das digitale Ausgangssignal.

In einer anderen bevorzugten Ausführungsform weist die Vorrichtung einen Mapper auf, dem die Vielzahl zweiter Startphasenwörter und die Vielzahl zweiter Endphasenwörter zugeführt sind und der ausgebildet ist, in Abhängigkeit der Vielzahl zweiter Startphasenwörter und der Vielzahl zweiter Endphasenwörter eine Vielzahl Mapperausgangssignale bereitzustellen, wobei ein jeweiliges der Mapperausgangssignale einen Impuls bildet, dessen Pulsweite und Phase durch ein jeweiliges Wortpaar, welches aus einem jeweiligen der Vielzahl zweiter Startphasenwörter und einem entsprechenden jeweiligen der Vielzahl zweiter Endphasenwörter gebildet ist, bestimmt werden.

Zusätzlich weist die Vorrichtung in dieser Ausführungsform einen Ausgangsmultiplexer auf, der ausgebildet ist, die Vielzahl Mapperausgangssignale in das digitale Ausgangssignal umzusetzen.

Auch diese Ausführungsform erlaubt eine nahezu vollständig digitale Umsetzung des Eingangssignals in das digitale Ausgangssignal und ist somit weitestgehend unabhängig von Schwankungen der PVT-Werte. Ebenfalls können Phase und Amplitude unabhängig voneinander moduliert werden, so dass amplituden- oder phasenspezifische Verzerrungen eines dem Ausgangssignalgenerator optional nachschaltbaren Leistungsverstärkers getrennt kompensiert werden können.

Bei der Ausführungsform mit dem Mapper werden die Phasen des Ausgangssignals, also die Flanken, von einem einzelnen Oszillator hoher Frequenz, z.B. ein Phase Locked Loop, abgeleitet. Dies resultiert in genauen Taktphasen im Ausgangssignal, die auch genauer sein können als bei der Ausführungsform mit dem Multiphasentaktsignalgenerator. Andererseits kann die letztere Ausführungsform bei einer niedrigeren Taktrate arbeiten und insofern einen geringeren Leistungsbedarf haben.

Ein weiterer Vorteil dieser Ausführungsform ist, dass der Ausgangssignalgenerator bei einer Ausgangssignalgeneratortaktrate betrieben werden kann, die bevorzugt im Wesentlichen ein N-faches der Grundfrequenz des zu kodierenden Eingangssignals beträgt. Bevorzugt ist die Ausgangssignalgeneratortaktrate, welches ein einphasiges Signal darstellt, quarzgenau von einer Schaltung, die in PLL (engl.: Phase Locked Lopp) - Technik implementiert ist, oder von einem Frequenzvervielfacher bereitgestellt.

Der Impuls eines jeweiligen Mapperausgangssignals wird beispielsweise durch eine Bitfolge hoher Datenrate gebildet. Der Mapper beinhaltet dazu in einer Ausführungsform einen ersten und einen zweiten Thermometerencoder, wobei dem ersten Thermometerencoder die Vielzahl zweiter Startphasenwörter und dem zweiten Thermometerencoder die Vielzahl zweiter Endphasenwörter zugeführt sind. Die Thermometerencoder können Standardthermometerencoder sein und identisch zueinander aufgebaut sein. Ausgangssignale des ersten Thermometerencoders sind in dieser Ausführungsform ersten Eingängen einer Vielzahl UND-Glieder zugeführt und invertierte Ausgangssignale des zweiten Thermometerencoders zweiten Eingängen der Vielzahl UND-Glieder. Die Ausgangssignale der Vielzahl UND-Glieder sind die Vielzahl Mapperausgangssignale.

Der Ausgangssignalmultiplexer kann beispielsweise von einem binären Zähler gesteuert sein, der bei der Ausgangssignalgeneratortaktrate betrieben ist.

In einer bevorzugten Ausführungsform sind/ist der Phasenkodierer bei einer Phasenkodierertaktrate und/oder der Phaseninterpolator bei einer Phaseninterpolatortaktrate betrieben, die jeweils wenigstens um den Faktor zwei geringer sind, als eine Ausgangssignalgeneratortaktrate, bei der der Ausgangssignalgenerator betrieben ist.

Diese Variante führt zu dem bereits eingangs genannten Vorteil des geringen Energiebedarfs der Vorrichtung. Die Verlustleistung einer Schaltungskomponente sinkt nämlich mit abnehmender Taktrate.

In einer besonders bevorzugten Ausführungsform ist der Phasenkodierer ausgebildet, das erste Startphasenwort und das erste Endphasenwort derart abzuleiten, , dass der Zeitpunkt der steigenden Flanke eines jeweiligen Ausgangsimpulses und der Zeitpunkt der fallenden Flanke des jeweiligen Ausgangsimpulses symmetrisch in Bezug auf eine Bezugsphase variiert sind.

In dieser Ausführungsform erfolgt demnach eine symmetrische Pulsweitenmodulation. Mittels der symmetrischen Pulsweitenmodulation moduliert die Vorrichtung die Amplitude unabhängig von der Phase, da sich die Phasenlage, z.B. die zeitliche Impulsmitte, aufeinanderfolgender Impulse des Ausgangssignals nicht ändert. Die Bezugsphase ist beispielsweise durch das Referenztaktsignal definiert.

Bevorzugt ist der Ausgangssignalgenerator ausgebildet, im digitalen Ausgangssignal
- einen Ausgangsimpuls mit zulässiger minimaler Pulsweite zu erzeugen und sodann ein Entstehen eines nachfolgenden Ausgangsimpulses zu unterdrücken oder
- ein Entstehen eines Ausgangsimpulses zu unterdrücken und sodann einen Ausgangsimpuls mit zulässiger minimaler Pulsweite zu erzeugen,
falls die Pulsweite des Zielimpulses ein unzulässiges Minimum unterschreitet.

Diese Ausführungsform hat den Vorteil, dass der Ausganssignalgenerator nur Impulse erzeugt, deren Pulsweite oberhalb des unzulässigen Minimums liegt, so dass ein optional nachschaltbarer Leistungsverstärker das digitale Ausgangssignal verzerrungsfrei verstärken kann. Das unzulässige Minimum kann frei definiert werden, ebenso die zulässige minimale Pulsweite, so dass die Vorrichtung an den optional nachschaltbaren Leistungsverstärker angepasst ist. Einen Zielimpuls, dessen Zielpulsweite das unzulässige Minimum unterschreitet, interpoliert der Ausgangssignalgenerator demnach beispielsweise durch abwechselndes Erzeugen eines Ausgangsimpulses mit zulässiger Pulsweite und Weglassen eines vorhergehenden oder nachfolgenden Ausgangsimpulses.

Das Eingangssignal umfasst beispielsweise ein Amplitudensignal und ein Phasensignal. Beispielsweise handelt es sich bei dem erzeugten digitalen Ausgangssignal um ein HF-Signal, dass eingangsseitig durch das Amplitudensignal und das Phasensignal, die beide digital vorliegen können, ausreichend beschrieben ist. Dann genügt es, nur das Amplitudensignal und das Phasensignal dem Phasenkodierer zuzuführen. Das Amplitudensignal und das Phasensignal können in Form eines digitalen Basisbandsignals vorliegen, also als ein Signal, das lediglich den Modulationsgehalt, nicht aber die Trägerfrequenz darstellt.

Der Phaseninterpolator umfasst zum Umwandeln bevorzugt wenigstens einen Delta-Sigma-Modulator (DSM). Bevorzugt beinhaltet der Phaseninterpolator einen ersten und einen zweiten Delta-Sigma-Modulator, wobei der erste Delta-Sigma-Modulator das erste Startphasenwort empfängt und die Vielzahl zweiter Startphasenwörter ausgibt und der zweite Delta-Sigma-Modulator das erste Endphasenwort empfängt und die Vielzahl zweiter Endphasenwörter ausgibt.

Ein Modulator dieses Typs zeigt besonders gute spektrale Eigenschaften. Der DSM kann ein Signal hoher Auflösung und niedriger Frequenz durch ein Signal niedriger Auflösung und hoher Frequenz interpolieren. Durch die niedrigere Auflösung der zweiten Phasenwörter könnte sich grundsätzlich ein numerisches Rauschen, ein sogenanntes Quantisierungsrauschen, ausbilden. Bei einem DSM lässt sich dieses Quantisierungsrauschen jedoch so beeinflussen, dass es bei Frequenzen weit außerhalb des Zielfrequenzbereichs des digitalen Ausgangssignals vergleichsweise stark und im Zielfrequenzbereich vergleichsweise gering ist. Ist ein Rekonstruktionsfilter nachgeschaltet, so dämpft dieses bevorzugt gerade die Frequenzteile mit dem vergleichsweise starken Quantisierungsrauschen, bevorzugt derart, dass Signalanteile im Zielfrequenzbereich von diesem Dämpfen nicht beeinflusst werden.

Ein Vorteil des DSM ist also, dass mit diesem ein durch das Umwandeln hervorgerufener möglicher Störeinfluss, wie das Verursachen des oben dargestellten Quantisierungsrauschens, auf Frequenzbereiche verschiebbar sind, die weit außerhalb vom des Zielfrequenzbereichs sind. Dadurch lässt sich die Signaldegeneration einfach wegfiltern.

Zudem lässt sich der DSM vollständig digital realisieren und ist dadurch unempfindlich gegenüber PVT-Variationen (PVT steht für: "Process, Voltage,. Temperature").

Diese positiven Eigenschaften des DSM wirken sich demnach vorteilhaft auf die gesamte Vorrichtung aus.

Einen zweiten Aspekt der vorliegenden Erfindung bildet ein Leistungsverstärker mit einer Vorrichtung nach einem der Ansprüche 1 bis 8. Insbesondere wird eine Anordnung vorgeschlagen, bei der der Leistungsverstärker das digitale Ausgangssignal des Ausgangssignalgenerators empfängt und sodann verstärkt und das verstärkte digitale Ausgangssignal ausgibt. Der Leistungsverstärker ist beispielsweise ein Klasse-D-Leistungsverstärker, der bevorzugt vollständig in digitaler Schalttechnik implementiert ist.

Einen dritten Aspekt der vorliegenden Erfindung bildet eine Sendeanordnung mit einer Vorrichtung nach einem der Ansprüche 1 bis 8 oder mit einem Leistungsverstärker nach Anspruch 9. Insbesondere wird eine Anordnung vorgeschlagen, bei der dem Ausgangssignalgenerator optional ein Leistungsverstärker nachgeschaltet ist und bei der dem Leistungsverstärker bzw. dem Ausgangssignalgenerator eine Sendeanordnung nachgeschaltet ist, die ausgebildet ist, dass verstärkte digitale Ausgangssignal bzw. das digitale Ausgangssignal nach extern hin auszusenden.

Gemäß einem vierten Aspekt der vorliegenden Erfindung wird ein Verfahren zum Kodieren eines Eingangssignals in ein digitales pulsweiten- und/oder phasenmoduliertes Ausgangssignal, im Folgenden als digitales Ausgangssignal bezeichnet, vorgeschlagen, welches die folgenden Schritten umfasst:
- Empfangen des Eingangssignals,
- Ableiten eines binären ersten Startphasenwortes und eines binären ersten Endphasenwortes aus dem Eingangssignal mit einer ersten Auflösung, wobei
   - das erste Startphasenwort einen Startzeitpunkt innerhalb einer Kodierperiode bestimmt, zu dem eine steigende Flanke eines Zielimpulses im digitalen Ausgangssignal auftreten soll, und das erste Endphasenwort einen Endzeitpunkt innerhalb der Kodierperiode bestimmt, zu dem eine fallende Flanke des Zielimpulses im digitalen Ausgangssignal auftreten soll,
- Umwandeln des ersten Startphasenwortes in eine Vielzahl zweiter binärer Startphasenwörter und des ersten Endphasenwortes in eine Vielzahl zweiter binärer Endphasenwörter mit einer zweiten Auflösung, die kleiner als die erste Auflösung ist, wobei
   - ein jeweiliges zweites Startphasenwort einen von N möglichen diskreten Zeitpunkten in der Kodierperiode beschreibt und damit den Startzeitpunkt mit der zweiten Auflösung annähernd bestimmt und ein jeweiliges zweites Endphasenwort einen der N möglichen diskreten Zeitpunkten in der Kodierperiode beschreibt und damit den Endzeitpunkt mit der zweiten Auflösung annähernd bestimmt,
- Umsetzen der Vielzahl zweiter Startphasenwörter und der Vielzahl zweiter Endphasenwörter in eine serielle Folge von Ausgangsimpulsen, wobei die serielle Folge von Ausgangsimpulsen im zeitlichen Mittel dem Zielimpuls entspricht, und
- Ausgeben der seriellen Folge von Ausgangsimpulsen als digitales Ausgangssignal.

Das Verfahren des vierten Aspektes der vorliegenden Erfindung teilt die Vorteile der Vorrichtung des ersten Aspektes der Erfindung. Das Verfahren des vierten Aspektes der Erfindung kann in verschiedenen Varianten ausgeführt werden und zusätzliche Schritte umfassen, wobei sich diese Varianten vor allem durch zusätzlichen Merkmale auszeichnen, die sinngemäß den zusätzlichen Merkmalen der Ansprüche 2 bis 8 entsprechen. Beispielsweise wird das Verfahren bevorzugt derart ausgeführt, dass die Pulsweiten aufeinanderfolgender Ausgangsimpulse symmetrisch zu einer Bezugsflanke variiert werden und/oder dass ein Zielimpuls mit unzulässig niedriger Pulsweite durch Erzeugen eines Impulses mit zulässiger minimaler Pulsweite und Weglassen eines vorhergehenden oder nachfolgenden Impulses im Ausgangssignal abgebildet wird.

Das erfindungsgemäße Verfahren stellt ein digitales Modulationsverfahren dar, das eine Phasenmodulation oder eine Pulsweitenmodulation oder eine kombinierte Phasen- und Pulsweitenmodulation realisiert. Dementsprechend wird im Folgenden auch von einem Phasenmodulationsverfahren oder einem Pulsweitenmodulationsverfahren gesprochen. Ist von einem Modulationsverfahren die Rede, so kann es sich um ein Phasenmodulationsverfahren oder ein Pulsweitenmodulationsverfahren handeln oder um ein Modulationsverfahren, das eine kombinierte Phasen- und Pulsweitenmodulation realisiert.

Insbesondere ist eine Ausführungsform des Verfahrens bevorzugt, bei dem das Umsetzen umfasst:
- Bereitstellen eines Referenztaktsignals,
- Ableiten eines Multiphasentaktsignals aus dem Referenztaktsignal, wobei das Multiphasentaktsignal eine Vielzahl um diskrete Phasenbeträge phasenverschobener Taktsignale aufweist, deren Phasenverschiebung gegenüber dem Referenztaktsignal sich beginnend mit Null von einem Taktsignal zum nächsten jeweils um einen Phasenabstand erhöht,
- Auswählen eines ersten der Vielzahl Taktsignale in Abhängigkeit der Vielzahl zweiter Startphasenwörter und Bereitstellen des ausgewählten ersten Taktsignals als Startphasensignal,
- Auswählen eines zweiten der Vielzahl Taktsignale in Abhängigkeit der Vielzahl zweiter Endphasenwörter und Bereitstellen des ausgewählten zweiten Taktsignals als Endphasensignal,
- Zusammenführen des Startphasensignals und des Endphasensignals zum Ausgangssignal, indem die das Startphasensignal die steigende Flanke eines jeweiligen Ausgangsimpulses im digitalen Ausgangssignal auslöst und das Endphasensignal die fallende Flanke des jeweiligen Ausgangsimpulses auslöst.

Bei einer anderen bevorzugten Ausführungsform des Verfahrens des vierten Aspektes der vorliegenden Erfindung umfasst das Umsetzen:
- Erzeugen einer Vielzahl Mapperausgangssignale in Abhängigkeit der Vielzahl zweiter Startphasenwörter und der Vielzahl zweiter Endphasenwörter mittels eines Mappers, wobei
   - ein jeweiliges der Mapperausgangssignale einen Impuls bildet, dessen Pulsweite und Phase durch ein jeweiliges Wortpaar, welches aus einem jeweiligen der Vielzahl zweiter Startphasenwörter und einem entsprechenden jeweiligen der Vielzahl zweiter Endphasenwörter gebildet ist, bestimmt werden, und
- serielles Ausgeben der Vielzahl Mapperausgangssignale als das digitale Ausgangssignal.

Das Erzeugen der Vielzahl Mapperausgangssignale erfolgt bevorzugt bei einer Erzeugungstaktrate, die wesentliche höher, wenigstens um den Faktor zwei höher ist, als die Taktrate, mit der das vorhergehende Ableiten und/oder als die Taktrate, mit der das vorhergehende Umsetzen erfolgt. Der Impuls eines jeweiligen Mapperausgangssignals wird beispielsweise durch eine Bitfolge hoher Datenrate gebildet, was bereits weiter oben mit Bezug auf die entsprechende Ausführungsform der Vorrichtung näher erläutert ist.

Einen fünften Aspekt der vorliegenden Erfindung bildet ein Verfahren zum Senden eines hochfrequenten Ausgangssignals, bei dem ein niederfrequentes Eingangssignal mit einem Verfahren gemäß dem vierten Aspekt der vorliegenden Erfindung in das hochfrequente digitale pulsweiten- und/oder phasenmodulierte Ausgangssignal transformiert wird und danach gesendet wird.

Weitere Ausführungsbeispiele sowie die Vorteile der Erfindung werden nachfolgend anhand der beiliegenden Figuren erläutert.

### Kurzbeschreibung der Figuren

Es zeigen in schematischer Darstellung:
- Fig. 1: einen HF Klasse-D-Leistungsverstärker nach dem Stand der Technik;
- Fig. 2: eine typische Implementierung eines Pulsweitenmodulators nach dem Stand der Technik;
- Fig. 3: eine Skizze zur Erläuterung eines erfindungsgemäßen zeitdiskreten Phasenmodulationsverfahrens;
- Fig. 4: eine Skizze zur Erläuterung eines erfindungsgemäßen zeitdiskreten Phasenmodulationsverfahrens mit Phaseninterpolation durch Dithering;
- Fig. 5: eine Skizze zur Erläuterung eines erfindungsgemäßen zeitdiskreten symmetrische Pulsweitenmodulationsverfahrens;
- Fig. 6: eine Skizze zur Erläuterung eines erfindungsgemäßen zeitdiskreten symmetrischen Pulsweitenmodulationsverfahrens mit Pulsweiten-Interpolation durch Dithering;
- Fig. 7: eine Skizze zur Erläuterung eines erfindungsgemäßen zeitdiskreten Pulsweitenmodulationsverfahrens mit Pulsweiten-Interpolation durch eine Maskierung kleiner Pulsweiten;
- Fig. 8: ein Ausführungsbeispiel einer erfindungsgemäßen Vorrichtung mit einem Multiphasentaktgenerator;
- Fig. 9: eine mögliche Implementierung der Synchronisationsschaltung aus Fig. 8;
- Fig. 10: ein weiteres Ausführungsbeispiel einer erfindungsgemäßen Vorrichtung mit einem Mapper;
- Fig. 11: eine schematische Darstellung eines Blockdiagramms einer Ausführungsform eines Mappers;
- Fig. 12: eine schematische Darstellung von Signalverläufen bei einer Ausführungsform der Vorrichtung mit einem Multiphasentaktsignalgenerator und
- Fig. 13: eine schematische Darstellung von Signalverläufen bei einer Ausführungsform der Vorrichtung mit einem Mapper.

### Ausführliche Beschreibung von Ausführungsbeispielen

Das erfindungsgemäße Modulationsverfahren soll im Folgenden vorgestellt werden. Phase und Amplitude des Eingangssignals können hier unabhängig von einander moduliert werden. Auf der Grundlage der Erfindung kann also eine Phasenmodulation, eine Pulsweitenmodulation oder eine kombinierte Phasen- und Pulsweitenmodulation realisiert werden.

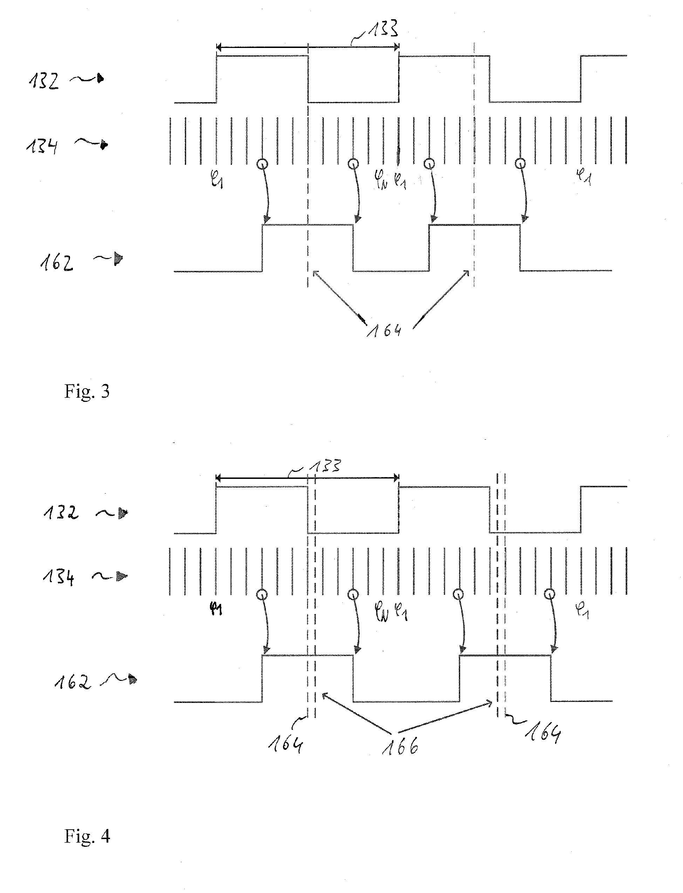

Zum besseren Verständnis sollen daher nachfolgend Phasen- und AmplitudenModulation getrennt behandelt werden. Dazu zeigen Fig. 3 bis 7 jeweils verschiedene Skizzen von Signalverläufen. Der oberste Signalverlauf stellt jeweils ein bereitgestelltes Referenztaktsignal 132 dar, das eine Referenztaktperiode 133 aufweist. Der mittlere Signalverlauf zeigt jeweils ein daraus abgeleitetes Multiphasentaktsignal 134, wobei die zueinander senkrechten Striche eine Vielzahl um diskrete Phasenbeträge phasenverschobener Taktsignale ϕ₁...ϕ_{N} andeuten, deren Phasenverschiebung gegenüber dem Referenztaktsignal 134 sich beginnend mit Null von einem Taktsignal zum nächsten jeweils um einen Phasenabstand erhöht. Der unterste Signalverlauf zeigt jeweils ein erzeugtes digitales Ausgangssignal 162, wobei senkrechte Linien eine Pulsmitte 164 eines Impulses im Ausgangssignal markieren oder eine Zielphasenlage 166. Ebenfalls sind dargestellt ein Zielimpuls 108 sowie ein Zielimpuls mit unzulässiger Pulsweite 168.

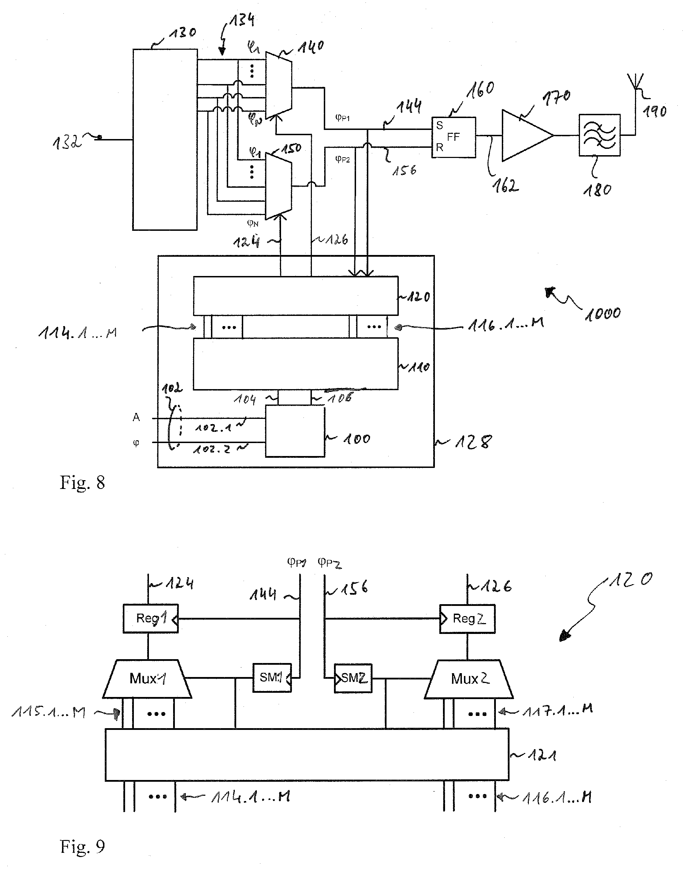

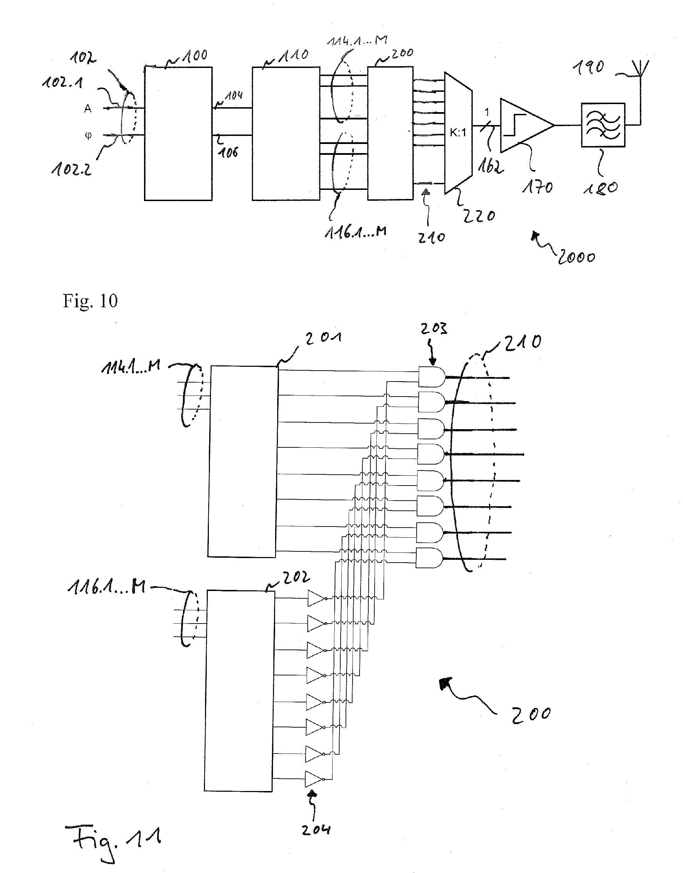

Eine Skizze zur Erläuterung des Prinzips des Phasenmodulationsverfahrens der Erfindung ist in Figur 3 dargestellt. Entsprechend Figur 3 wird aus einem Referenztaktsignal 132 ein Multiphasentaktsignal 134 abgeleitet. Das Referenztaktsignal 132 kann eine Frequenz haben, die genau gleich einer Trägerfrequenz des Ausgangssignals 162 (beispielsweise dargestellt in Fig. 8 und 10) ist, oder etwas davon abweichen. Durch Auswahl von diskreten Phasen ϕ₁...ϕ_{N} des Multiphasentaktsignals 134, also durch Auswahl von Taktsignalen, die um diskrete Phasenbeträge phasenverschoben sind, wird ein digitales Ausgangssignal 162 mit Impulsen konstanter Pulsweite erzeugt, deren Phasenlage im Raster des Multiphasentaktsignals 134 einstellbar ist. Hierdurch lässt sich eine zeitdiskrete Phasenmodulation realisieren.

Im Allgemeinen möchte man nicht nur zeitdiskrete (ϕ₁...ϕ_{N}), sondern beliebige Phasenwerte erzeugen. Dies kann durch Phaseninterpolation erreicht werden. Hierbei werden die diskrete Phasenwerte ϕ₁...ϕ_{N} gemäß einem geeigneten Interpolationsverfahren so umgeschaltet, dass sich im Mittel die Zielphase ergibt, wie in Figur 4 dargestellt. Diese Technik kann auch als Dithering bezeichnet werden. Aufgrund seiner günstigen spektralen Eigenschaften ist zum Beispiel die Phaseninterpolation mittels Delta-Sigma-Modulation der Phase gut geeignet. Bei geeigneter schmalbandiger Auslegung eines optional nachschaltbaren Rekonstruktionsfilters und hoher Umschaltfrequenz der Phase, also hoher Ausgangssignalgeneratortaktrate, werden Phasensprünge im digitalen Ausgangssignal 162 durch das Rekonstruktionsfilter herausgemittelt.

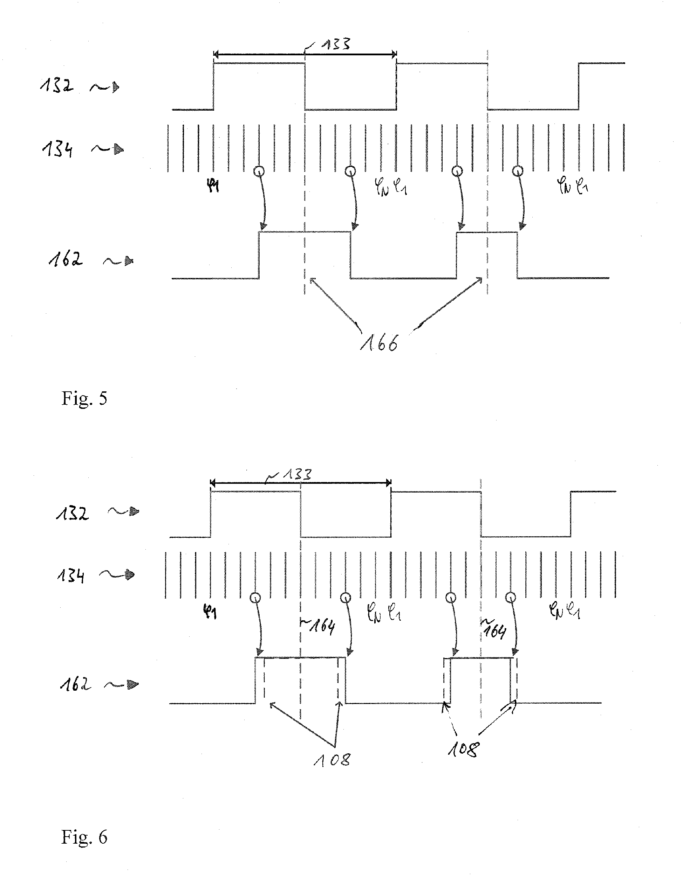

In Figur 5 ist nun eine zeitdiskrete symmetrische Pulsweitenmodulation (PWM) gezeigt. Hier wird durch Wahl unterschiedlicher Phasen ϕ₁...ϕ_{N} des Multiphasentaktsignals 134 ein diskret pulsweitenmoduliertes digitales Ausgangsignal 162 erzeugt. Bei der reinen PWM ohne Phasenmodulation werden dabei die steigenden und fallenden Flanken eines Impulses im digitalen Ausgangssignale 162 immer symmetrisch zu der festen Zielphasenlage 166 ausgewählt, so dass die Phasenlage des pulsweitenmodulierten digitalen Ausgangssignalsignals 162 (z. B. die Mitte eines Impulses) immer gleich bleibt.

Soll nun eine kontinuierliche Pulsweite interpoliert werden, d.h. ein Zielimpuls erzeugt werden, der durch einen einzigen Impuls, dessen Zeitpunkte der steigende Flanke und der fallenden Flanke durch ein Wortpaar aus einem zweiten Startphasenwort und einem zweiten Endphasenwort bestimmt sind, nicht darstellbar ist, kann analog wie bei der Phasenmodulation vorgegangen werden. Dieser Fall ist in Figur 6 gezeigt. Dort wird die Zielpulsweite des Zielimpulses 108 durch Umschalten zwischen diskreten Pulsweiten so angenähert, dass sich im Mittel die Zielpulsweite im digitalen Ausgangssignal 164 ergibt. Am Ausgang eines optional nachschaltbaren Rekonstruktionsfilters erscheint ein amplitudenmoduliertes Signal, dessen Amplitude der entsprechenden Zielpulsweite entspricht.

Ein bevorzugtes erfindungsgemäßes Modulationsverfahren ergibt sich aus einer gleichzeitigen Anwendung von interpolierender Phasenmodulation und interpolierender symmetrischer Pulsweitenmodulation.

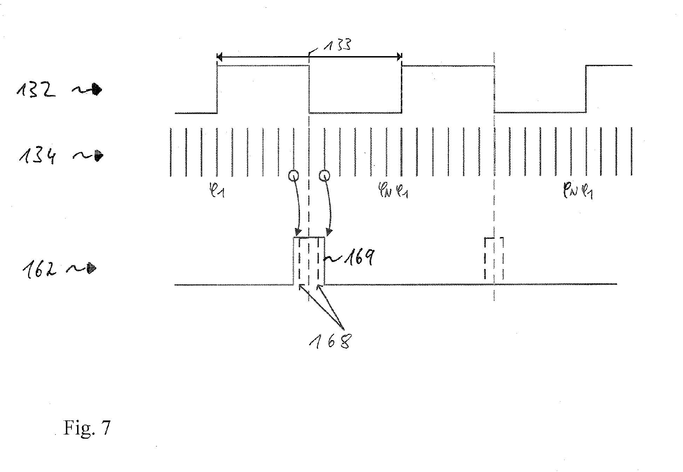

Eine vorteilhafte Ausgestaltung des Modulationsverfahrens verhindert zu kleine Pulsweiten und wird im Folgenden mit Bezug auf Fig. 7 beschrieben. Wenn die Pulsweite 168 des digitalen Ausgangssignals 162, das ein Eingangssignal für einen optional nachschaltbaren Schaltverstärker bilden kann, zu klein ist, kann dieser das digitale Ausgangssignal 162 nicht mehr verzerrungsfrei verstärken, da eine volle Ausgangsamplitude nicht erreicht wird. Das erfindungsgemäße Modulationsverfahren erlaubt zusätzlich die Unterdrückung (Maskierung) zu kleiner Pulsweiten 168. Die minimal erlaubte Pulsweite 169 kann je nach verwendetem Leistungsverstärker beliebig programmiert werden. Um dennoch kleinere Pulsweiten 168 interpolieren zu können wird wie in Figur 7 gezeigt vorgegangen. Dort werden Zielpulsweiten 168, die kleiner als die minimale Pulsweite 169 sind, durch geeignetes Umschalten zwischen minimaler Pulsweite und Weglassen des Impulses interpoliert. Die Interpolation kann mit verschiedenen Vorschriften durchgeführt werden, unter anderem mit der Delta-Sigma-Modulation.

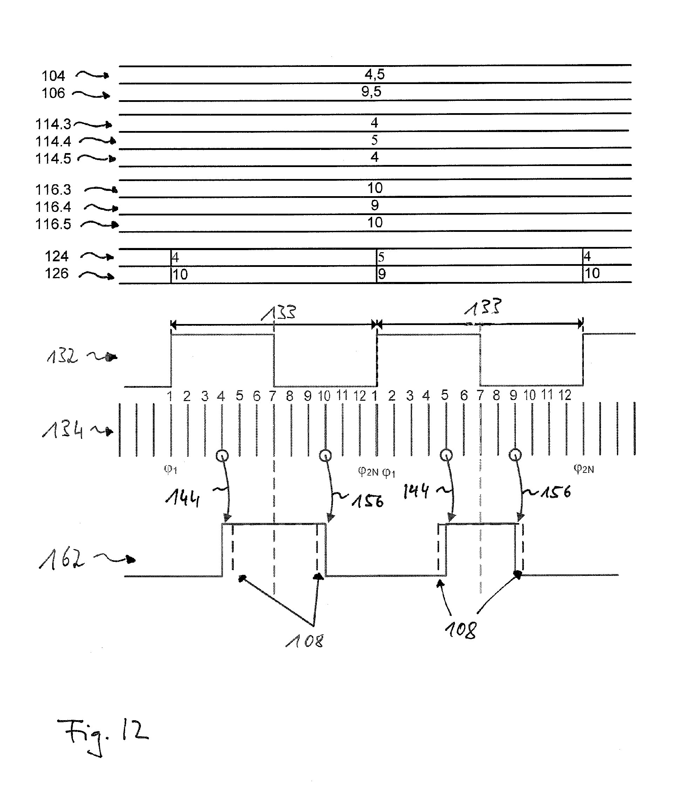

Das erfindungsgemäße Modulationsverfahren kann beispielsweise durch die in Figur 8 gezeigte Schaltung 1000, die eine Ausführungsform der erfindungsgemäßen Vorrichtung mit einem Multiphasentaktsignalgenerator beinhaltet, implementiert werden. Eine schematische Darstellung von Signalverläufen bei dieser Ausführungsform der Vorrichtung mit einem Multiphasentaktsignalgenerator zeigt Fig. 12, auf die im Folgenden ebenfalls Bezug genommen wird. Diese Schaltung 1000 erzeugt aus einem Eingangssignal 102 in Gestalt eines digitalen Amplitudensignals 102.1 und eines digitalen Phasensignals 102.2 das digitale pulsweite- und/oder phasenmodulierte Ausgangssignal 162. Zusätzlich beinhaltet die Schaltung 1000 einen nachgeschalteten Leistungsverstärker 170, ein Rekonstruktionsfilter 180 und eine Sendeanordnung 190 zum Aussenden des verstärkten und gefilterten digitalen Ausgangssignals.

Die in Fig. 8 gezeigte Vorrichtung umfasst einen Phasenkodierer 100, einen Phaseninterpolator 110 und eine Synchronisationsschaltung 120, die in ihrer Gesamtheit eine Pulssteuerschaltung 128 bilden. Diese Pulssteuerschaltung 128 stellt ein Startphasenauswahlsignal 124 und ein Endphasenauswahlsignal 126 bereit, die einem Starphasenmultiplexer 140 bzw. einem Endphasenmultiplexer 150 zugeführt sind.

Außerdem umfasst die Vorrichtung aus Fig. 8 einen Multiphasentaktsignalgenerator 130, der aus einem ihm zugeführten Referenztaktsignal 132 ein weiter oben bereits charakterisiertes Multiphasentaktsignal 134 mit einer Vielzahl N zueinander phasenverschobener Taktsignale ableitet, vgl. Fig. 12. Der Starphasenmultiplexer 140 und der Endphasenmultiplexer 150 empfangen das Multiphasentaktsignal 134. Ihre Ausgänge sind auf Eingänge eins Signalkombinierers 160 gekoppelt, der das digitale Ausgangssignal 162 erzeugt. Somit bilden der Multiphasentaktsignalgenerator, der Starphasenmultiplexer 140 und der Endphasenmultiplexer 150 sowie der Signalkombinierer 160 einen Ausgangssignalgenerator, der von der Pulssteuerschaltung 128 gesteuert ist.

Der Startphasenmultiplexer 140 wählt eines der Vielzahl phasenverschobener Taktsignale ϕ_{P1} in Abhängigkeit des Startphasenauswahlsignals 124 aus und der Endphasenmultiplexer eine eines der Vielzahl phasenverschobener Taktsignale ϕ_{P2} in Abhängigkeit des Endphasenauswahlsignals 126. Die ausgewählten Signale geben sie als Startphasensignal 144 bzw. Endphasensignal 156 aus. Diese Signale sind Eingängen des Signalkombinierers 160, der hier beispielsweise in Gestalt eines RS-Flipflops vorliegt, zugeführt. Am Ausgang des Signalkombinierers 160 erscheint das digitale Ausgangssignal 162, wobei eine steigende Flanke eines jeweiligen Impulses durch das Startphasensignal 144 (ϕ_{P1}) und eine fallende Flanke des jeweiligen Impulses durch das Endphasensignal 156 (ϕ_{P2}) ausgelöst wird. Dem Signalkombinierer 160 sind der Leistungsverstärker 170, das Rekonstruktionsfilter 180 und die Sendeanordnung 190 nachgeschaltet.

Am Eingang der Pulssteuerschaltung 128 liegen das Amplitudensignal 102.1 in Gestalt eines Basisbandsignals A, das die Einhüllende (Amplitude) repräsentiert, und das Phasensignal 102.2 in Gestalt eines Basisbandsignals ϕ, das die Phase repräsentiert, an. Diese beiden Basisbandsignale bilden das Eingangssignal 102.

Hierbei kann die Taktfrequenz der Basisbandsignale A, ϕ wesentlich kleiner sein als die Frequenz des Referenztaktsignals 132.

Die Pulssteuerschaltung 128 leitet aus den beiden Basisbandsignalen A und ϕ mittels des Phasenkodierers ein binäres erstes Startphasenwort 104 und ein binäres erstes Endphasenwort 106 mit einer ersten Auflösung ab. In dem in Fig. 12 gezeigten Beispiel hat das erste Startphasenwort 104 den Wert 4,5 und das erste Endphasenwort den Wert 9,5. Damit ist ein Zielimpuls 108 festgelegt, der im untersten Verlauf in Fig. 12 mit gestrichelten Linien dargestellt ist.

Das erste Startphasenwort 104 und das erste Endphasenwort 106 bestimmen im Ergebnis, welche Taktphasen/Taktsignale des Multiphasentaktsignals 134 für die Pulserzeugung ausgewählt werden, wobei das Taktsignal ϕ_{P1} durch das erste Startphasenwort 104 und das Taktsignal ϕ_{P2} durch das erste Endphasenwort 106 bestimmt sind. Mit anderen Worten bestimmt das erste Startphasenwort 104 einen Startzeitpunkt innerhalb einer Kodierperiode, zu dem eine steigende Flanke eines Zielimpulses im digitalen Ausgangssignal 162 auftreten soll, und das erste Endphasenwort 106 einen Endzeitpunkt innerhalb der Kodierperiode, zu dem eine fallende Flanke des Zielimpulses im digitalen Ausgangssignal 162 auftreten soll.

Der Phaseninterpolator 110 ist dem Phasenkodier 100 nachgeschaltet ist und wandelt mit einer zweiten Auflösung, die kleiner als die erste Auflösung ist, das erste Startphasenwort 104 in eine Vielzahl M zweiter binärer Startphasenwörter 114.1...M und das erste Endphasenwort 106 in eine Vielzahl M zweiter binärer Endphasenwörter 116.1...M um. In dem in Fig. 12 gezeigten Beispiel betragen die Vielzahl zweiter Startphasenwörter 4, 5 und 4 und die Vielzahl zweiter Endphasenwörter 10, 9 und 10.

Durch die Anzahl N der Taktsignale/Taktphasen ist die Wortbreite eines jeweiligen zweiten Startphasenwortes 114.i und eines jeweiligen zweiten Endphasenwortes 116.i festgelegt. Sie beträgt wenigstens Id(N) Bit.

Ein jeweiliges zweites Startphasenwort 114.i beschreibt einen von N möglichen diskreten Zeitpunkten in der Kodierperiode und bestimmt damit annähernd den Startzeitpunkt mit der zweiten Auflösung. Ein jeweiliges zweites Endphasenwort 116.i beschreibt einen der N möglichen diskreten Zeitpunkte in der Kodierperiode und bestimmt damit annähernd den Endzeitpunkt mit der zweiten Auflösung. Die Phaseninterpolator 110 wandelt demnach das erste Startphasenwort 104 und das erste Endphasenwort 106 derart um, dass mit der Vielzahl M zweiter binärer Startphasenwörter 114.1...M der Vielzahl M zweiter binärer Endphasenwörter 116.1...M diese (104, 106) interpoliert werden können, beispielsweise mit Hilfe eines Delta-Sigma-Modulators.

Die Wortbreiten des ersten Startphasensignals 104 und des ersten Endphasensignals 106 sind also typischerweise höher als die Wortbreiten eines jeweiligen zweiten Startphasenwortes 114.i und eines jeweiligen zweiten Endphasenwortes 116.i. Die Wortbreiten des ersten Startphasensignals 104 und des ersten Endphasensignals 106 können beliebig lang sein, sprich die erste Auflösung kann beliebig hoch sein, und sind/ist nicht von der Anzahl der realisierbaren Taktsignale N abhängig.

Die Vielzahl M zweiter Startphasenwörter 114.1...M und die Vielzahl M zweiter Endphasenwörter 116.1... M können jeweils als Vektoren vorliegen.

Am Eingang der Synchronisationsschaltung 120 liegen das Startphasensignal 144 (ϕ_{P1}) und das Endphasensignal 156 (ϕ_{P2})an, die zur Synchronisation des Startphasenauswahlsignals 124 und des Endphasenauswahlsignals 126 benötigt werden. Hierbei wird ein aktuelles Startphasenauswahlsignal 124 durch ein vorhergehendes Startphasensignal 144 und ein aktuelles Endphasenauswahlsignal 126 durch ein vorhergehendes Endphasensignal 156 synchronisiert.

Die Synchronisationsschaltung 120 hat an ihrem Eingang die Vielzahl M zweiter Startphasenwörter 114.1...M und die Vielzahl M zweiter Endphasenwörter 116.1...M anliegen und multiplext diese auf die M-fache Datenrate, so dass ein jeweiliges zweites Startphasenwortes 114.i und jeweiliges zweites Endphasenwortes 116.i am Ausgang der Pulssteuerschaltung 128 und somit als Startphasenauswahlsignal 124 bzw. als Endphasenauswahlsignal 126 an Steuereingängen des Startphasenmultiplexers 140 bzw. des Endphasenmultiplexers 150 anliegen.

Im Ergebnis liefert die Synchronisationsschaltung 120 das Startphasenauswahlsignal 124 und das Endphasenauswahlsignal 126 an die entsprechenden Multiplexer 140 bzw. 150. Auch diese Signale sind in Fig. 12 dargestellt. In Abhängigkeit dieser Signale schalten die Multiplexer 140, 150 eines ihrer Eingangssignale auf ihren jeweiligen Ausgang durch. Dies ist für zwei Fälle, nämlich für den Fall {zweites Startphasenwort = 4 ; zweites Endphasenwort = 10} und für den Fall {zweites Startphasenwort = 5 ; zweites Endphasenwort = 9} in Fig. 12 dargestellt. Entsprechend fällt das Ausgangssignal 162 aus und auf diese Weise wird der vom Phasenkodierer 100 ermittelte Zielimpuls 108 angenähert (sog. Dithering).

Eine mögliche Implementierung der Synchronisationsschaltung 120 ist in Figur 9 gezeigt. Das rückgekoppelte Startphasensignal 144 taktet einen ersten Zustandsautomaten SM1, der ein erstes Steuersignal für einen ersten Multiplexer Mux1 erzeugt. Außerdem taktet das rückgekoppelte Startphasensignal 144 ein erstes Register Reg1, wodurch das Startphasenauswahlsignal 124 mit dem rückgekoppelten Startphasensignal 144 synchronisiert ist, d.h. auf dieses zeitlich abgestimmt ist. Analog taktet das rückgekoppelte Endphasensignal 156 ein zweites Register Reg2 und einen zweiten Zustandsautomaten SM2, der einen zweiten Multiplexer Mux2 steuert. Auf diese Weise ist das Endphasenauswahlsignal 126 mit dem Endphasensignal 156 synchronisiert, d.h. auf dieses zeitlich abgestimmt.

Da an den Multiplexern 140 und 150 eine Vielzahl von Signalen 134 mit unterschiedlichen Taktphasen anliegen und auch die Phasen der Signale 144 und 156 variieren, könnte es ohne eine Synchronisationsschaltung passieren, dass in einem Umschaltzeitpunkt des Multiplexers 140 und/oder 150 ein oder mehrere der oben genannten Phasensignale 134, 144 und/oder 156 eine ansteigende und/oder abfallende Flanke aufweisen. Dadurch können das Signal 144 und/oder 156 verzerrte Flanken aufweisen und ein Taktphasenraster würde nicht mehr eingehalten werden. Daher sollte eine Umschaltung bei den Multiplexern 140 und/oder 150 zu einem Zeitpunkt stattfinden, an dem weder die Signale 144 und 156 noch ein neues durchzuschaltendes Signal aus der Vielzahl von Signalen 134 eine steigende oder fallende Flanke aufweisen.

Geht man davon aus, dass bei der Interpolation der Phase und Pulsweite vor allem zwischen zueinander unmittelbar benachbarten Phasen umgeschaltet wird, dann lässt sich eine Synchronisation vorteilhaft dadurch erreichen, dass die Signale 144 und 156 genutzt werden, um die Multiplexersteuersignale 124 und 126 und die Zustandsautomaten SM1 und SM2 zu takten. Die Register Reg1 und Reg2 sollten dann langsam genug sein, dass Multiplexersteuersignale 124 und 126 erst dann ausgegeben werden und somit ein Umschalten im Startphasenmultiplexer 140 bzw. Im Endphasenmultiplexer 160 bewirken, wenn das Startphasensignal 144 bzw. das Endphasensignal 156 ausreichend lange stabil angelegen haben.

Der Startphasenmultiplexer 140 und der Endphasenmultiplexer 150 erzeugen das Startphasensignal 144 bzw. das Endphasensignal 156 mit einer Taktfrequenz, die M mal so hoch ist wie die Frequenz der Basisbandsignale A und ϕ. Beide Signale haben eine wechselnde Phasenlage. Weil die Steuerung des ersten und des zweiten Multiplexers Mux1, Mux2 über den ersten und den zweiten Zustandsautomaten SM1 bzw. SM2 erfolgt, welche den wechselnden Phasenlagen des Startphasensignals 144 bzw. des Endphasensignals 156 folgen, ändern sich die Anforderungen an die Phasenlage der Eingangssignalen (115.1...M und 117.1...M) von Mux1 und Mux2 während des Betriebes laufend. Demgegenüber haben die übrigen Basisbandsignale A und ϕ einen starren Takt. Von daher ist zusätzlich ein Synchronisationsblock 121 vorgesehen, der die Aufgabe hat, die Vielzahl M zweiter Startphasenwörter 114.1...M und die Vielzahl M zweiter Endphasenwörter 116.1...M zunächst geeignet zu verzögern, so dass Vielzahl M zweiter Startphasenwörter 114.1...M und die Vielzahl M zweiter Endphasenwörter 116.1...M phasenrichtig an den Eingängen des ersten Multiplexer Mux1 bzw. des zweiten Multiplexers Mux2 als entsprechende Eingangssignalen 115.1...M und 117.1...M anliegen. Hierzu sind Ausgangssignale des ersten Zustandsautomaten SM1 und des zweiten Zustandsautomaten SM2 dem Synchronisationsblock 121 zugeführt, die einen darin installierten Pufferspeicher asynchron auslesen. Eine Möglichkeit, den Synchronisationsblock 121 zu realisieren, bilden beispielsweise zwei First-In-First-Out (FIFO) Speicher.

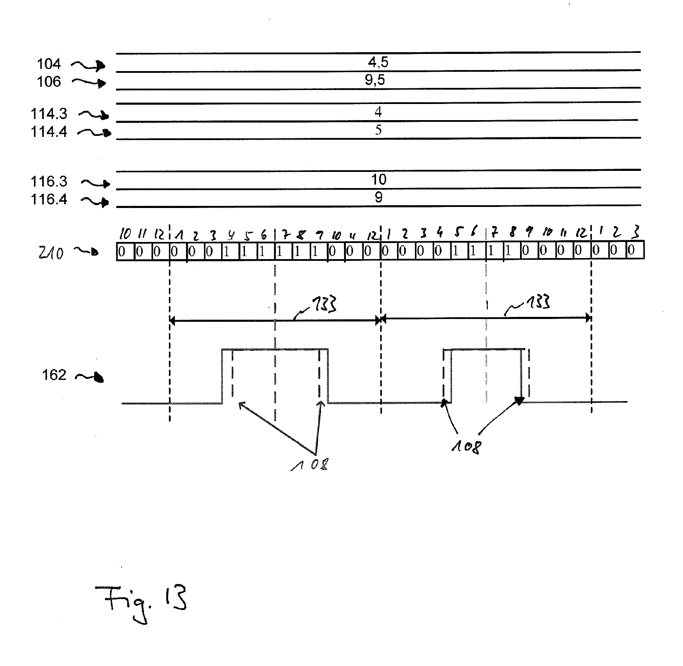

Das erfindungsgemäße Modulationsverfahren kann ebenfalls durch eine in Figur 10 gezeigte Schaltung 2000, die eine Ausführungsform der erfindungsgemäßen Vorrichtung mit einem Mapper beinhaltet, implementiert werden. Entsprechende Signalverläufe bei dieser Ausführungsform sind beispielhaft in Fig. 13 gezeigt. Auf diese Figur wird im Folgenden ebenfalls Bezug genommen. Die Schaltung 200 erzeugt aus dem Eingangssignal 102 in Gestalt eines digitalen Amplitudensignals 102.1 und eines digitalen Phasensignals 102.2 das digitale pulsweite- und/oder phasenmodulierte Ausgangssignal 162.

Die Schaltung 2000 umfasst, wie die Schaltung 1000 auch, einen Phasenkodierer 100 und einen Phaseninterpolator 110, die in den zu Fig. 8 und Fig. 12 bereits geschilderte Weisen operieren. Der Ausgangssignalgenerator umfasst hier jedoch keinen Multiphasentaktsignalgenerator und keinen Signalkombinierer im obigen Sinne, sondern einen Mapper 200 und einen diesem nachgeschalteten Ausgangsmultiplexer 220, der das digitale Ausgangssignal 162 erzeugt.

Dem Ausgangsmultiplexer 220 nachgeschaltet sind ein Leistungsverstärker 170, ein Rekonstruktionsfilter 180 und eine Sendeanordnung 190 zum Aussenden des verstärkten und gefilterten digitalen Ausgangssignals.

Die Schaltungskomponenten 100, 110 und 200 sind bevorzugt auf einen gemeinsamen digitalen Signalprozessor, im Folgenden DSP, implementiert. Ebenfalls kann der Ausgangsmultiplexer 220 Teil des DSPs sein.

Grundsätzlich operiert die Schaltung 2000 wie folgt: Eingangsseitig liegen das Eingangssignal in Gestalt eines Basisbandsignals A, das eine Amplitude repräsentiert (Amplitudensignal 102.1) und eines Basisbandsignals ϕ, das eine Phase repräsentiert (Phasensignal 102.2) an. Der Mapper 200 erzeugt in Abhängigkeit der Vielzahl M zweiter Startphasenwörter 114.1...M und die Vielzahl M zweiter Endphasenwörter 116.1...M, gemäß dem in Fig. 13 gezeigten Beispiel in Abhängigkeit der Wortpaare {4 ; 10} und {5 ; 9}, eine Vielzahl M Mapperausgangssignale 210, die dem schnellen Ausgangsmultiplexer 220 zugeführt wird. Der Ausgangsmultiplexer 220 erzeugt aus der Vielzahl M Mapperausgangssignale 210 das digitale Ausgangssignal 162 in Gestalt eines seriellen 1 Bit breiten Bitstroms mit einer Bitrate *f*_{BIT}, die wesentlich größer als die Frequenz *f*_{EIN} des Eingangssignals 102 ist.

Der Leistungsverstärker 170 erzeugt ein verstärktes Pulssignal, welches über das Rekonstruktionsfilter 180 der Sendeanordnung, beispielsweise eine Antenne, zugeführt ist. Das digitale Ausgangssignal 162 bildet ein 1 Bit breites phasen-und pulsweitenmoduliertes Signal. Ist z. B. *f*_{BIT} = N**f*_{EIN}, erhält man ein pulsweiten- und phasenmoduliertes Signal mit N diskreten Taktphasen.

Die Vielzahl M zweiter Startphasenwörter 114.1...M und die Vielzahl M zweiter Endphasenwörter 116.1...M liegen, beispielsweise jeweils in Gestalt eines Vektors, am Eingang des Mappers an, der in Abhängigkeit dieser die Vielzahl Mapperausgangssignale 210 bereit-stellt, wobei ein jeweiliges der Mapperausgangssignale 210 einen Impuls bildet, dessen Pulsweite und Phase durch ein jeweiliges Wortpaar, welches aus einem jeweiligen der Vielzahl zweiter Startphasenwörter 114.i, wobei i ein Element der Zahlenreihe 1...M ist, und einem entsprechenden jeweiligen der Vielzahl zweiter Endphasenwörter 116.i gebildet ist, bestimmt werden. Ein Mapperausgangssignal ist also ein konstruiertes Datenwort, das jeweils einer Periode eines PWM-Signals entspricht, also z.B. aus N Bit besteht, wobei N wiederum die Zahl der diskreten Phasen des digitalen Ausgangssignals darstellt. Das konstruierte Datenwort besteht dabei aus einer Folge aufeinanderfolgender Einsen und Nullen, wobei jeweils ein 0-1-Übergang an der Stelle stattfindet, die durch das jeweilige zweite Startphasenwort 114.i gekennzeichnet ist und ein 1-0-Übergang an der Stelle stattfindet, die durch das jeweilige zweite Endphasenwort 116.1 gekennzeichnet ist. Um mit Bezug auf Fig. 13 ein Beispiel zu nennen: N = 12; Zahlenwert eines zweiten Startphasenwortes 114.3 = 4 und Zahlenwert eines zweiten Startphasenwortes 114.4 = 5; Zahlenwert eines zweiten Endphasenwortes 116.3 = 10 und Zahlenwert eines zweiten Endphasenwortes 116.4 = 9. Diese Konstellation führt zu einem ersten konstruierten Datenwort von 000111111000, d.h. zu einem Impuls, der dieses erste Datenwort abbildet, also ein Impuls, der während den ersten und letzten drei Zwölften einer PWM-Periode den Wert 0 hat, und dazwischen den Wert 1, und zu einem zweiten konstruierten Datenwort von 000011110000, d.h. zu einem Impuls, der dieses zweite Datenwort abbildet, also ein Impuls, der während den ersten und letzten vier Zwölften einer PWM-Periode den Wert 0 hat, und dazwischen den Wert 1.. Demnach konstruiert der Mapper 200 aus M Wortpaaren M Datenworte mit N Bit Wortlänge in Gestalt entsprechender kurzer Impulse 210, die er parallel an den nachfolgenden Ausgangsmultiplexer 220 ausgibt. Der Ausgangsmultiplexer multiplext die K = M*N Bits zu einem 1 Bit breiten Bitstrom und erzeugt so das digitale Ausgangssignal 162. Aus der Fig. 12 geht wiederum hervor, dass so der Zielimpuls 108 angenähert wird.

Fig. 11 zeigt in schematischer Darstellung eine mögliche Ausführungsform des Mappers 200. Der Mapper beinhaltet in dieser Ausführungsform einen ersten Thermometerencoder 201 und einen zweiten Thermometerencoder 202, wobei dem ersten Thermometerencoder 201 die Vielzahl zweiter Startphasenwörter 114.1...M und dem zweiten Thermometerencoder 202 die Vielzahl zweiter Endphasenwörter 116.1...M zugeführt sind. Die Thermometerencoder 201 und 202 können Standardthermometerencoder sein und identisch zueinander aufgebaut sein. Ausgangssignale des ersten Thermometerencoders 201 sind ersten Eingängen einer Vielzahl UND-Glieder 203 zugeführt und Ausgangssignale des zweiten Thermometerencoders 202 einer Vielzahl Inverter 204. Die invertierten Ausgangssignale des zweiten Thermometerencoders 202 sind zweiten Eingängen der Vielzahl UND-Glieder 203 zugeführt. Die Ausgangssignale der Vielzahl UND-Glieder sind die Vielzahl Mapperausgangssignale 210.

### Bezugszeichenliste

- 100: Phasenkodierer
- 102: Eingangssignal
- 102.1: Amplitudensignal
- 102.2: Phasensignal
- 104: erstes Startphasenwort
- 106: zweites Startphasenwort
- 108: Zielimpuls
- 110: Phaseninterpolator
- 114.1...M: Vielzahl zweiter Startphasenwörter
- 115.1...M: Eingangssignale des ersten Multiplexers Mux1
- 116.1... M: Vielzahl zweiter Endphasenwörter
- 117.1...M: Eingangssignale des zweiten Multiplexers Mux2
- 120: Synchronisationsschaltung
- 121: Synchronisationsblock
- 124: Startphasenauswahlsignal
- 126: Endphasenauswahlsignal
- 128: Pulssteuerschaltung
- 130: Multiphasentaktsignalgenerator
- 132: Referenztaktsignal
- 133: Referenztaktsignalperiode
- 134: Multiphasentaktsignal
- 140: Startphasenmultiplexer
- 144: Startphasensignal
- 150: Endphasenmultiplexer
- 156: Endphasensignal
- 160: Signalkombinierer
- 162: digitales Ausgangssignal
- 164: Pulsmitte eines Impulses im Ausgangssignal
- 166: Zielphasenlage
- 168: Zielimpuls mit unzulässiger Pulsweite
- 169: Ausgangsimpuls mit zulässiger minimaler Pulsweite
- 170: Leistungsverstärker
- 180: Rekonstruktionsfilter
- 190: Sendeanordnung
- 200: Mapper
- 201: erster Thermometerencoder
- 202: zweiter Thermometerencoder
- 203: Vielzahl UND-Glieder
- 204: Vielzahl Inverter
- 210: Vielzahl Mapperausgangssignale
- 220: Ausgangsmultiplexer
- 1000: Vorrichtung mit Multiphasentaktsignalgenerator
- 2000: Vorrichtung mit Mapper
- SM1: erster Zustandsautomat
- SM2: zweiter Zustandsautomat
- Reg1: erstes Register
- Reg2: zweites Register
- Mux1: erster Multiplexer
- Mux2: zweiter Multiplexer

### Variablen

- M: Anzahl zweiter Startphasenwörter / Anzahl zweiter Endphasenwörter
- N: Anzahl diskreter Taktphasen im digitalen Ausgangssignal 162 / Anzahl zueinander phasenverschobener Taktsignale bzw. Taktphasen
- n: zweite Auflösung
- a: erste Auflösung
- ϕ_{P1}: Startphasenlage
- ϕ_{P2}: Endphasenlage
- ϕ₁...ϕ_{N}: Verfügbare diskrete Phasenlagen im Multiphasentaktsignal
- A: Eingangssignal in Gestalt eines digitalen Basisbandsignals, das eine Amplitude repräsentiert
- ϕ: Eingangssignal in Gestalt eines digitalen Basisbandsignals, das eine Phase repräsentiert

## Patentansprüche

1. Vorrichtung (1000; 2000) zum Kodieren eines Eingangssignals (102) in ein digitales pulsweiten- und/oder phasenmoduliertes Ausgangssignal (162), im Folgenden als digitales Ausgangssignal (162) bezeichnet, umfassend:
- einen Eingang zum Empfangen des Eingangssignals (102) und einen Ausgang zum Ausgeben des digitalen Ausgangssignals (162),
- einen Phasenkodierer (100), der ausgebildet ist, aus dem Eingangssignal (102) ein binäres erstes Startphasenwort (104) und eines binäres erstes Endphasenwort (106) mit einer ersten Auflösung abzuleiten, wobei
- das erste Startphasenwort (104) einen Startzeitpunkt innerhalb einer Kodierperiode bestimmt, zu dem eine steigende Flanke eines Zielimpulses (108) im digitalen Ausgangssignal (162) auftreten soll, und das erste Endphasenwort (106) einen Endzeitpunkt innerhalb der Kodierperiode bestimmt, zu dem eine fallende Flanke des Zielimpulses (108) im digitalen Ausgangssignal (162) auftreten soll,
- einen Phaseninterpolator (110), der dem Phasenkodier (100) nachgeschaltet ist und ausgebildet ist, mit einer zweiten Auflösung, die kleiner als die erste Auflösung ist, das erste Startphasenwort (104) in eine Vielzahl zweiter binärer Startphasenwörter (114.1...M) und das erste Endphasenwort (106) in eine Vielzahl zweiter binärer Endphasenwörter (116.1...M) umzuwandeln,
- wobei ein jeweiliges zweites Startphasenwort einen von N möglichen diskreten Zeitpunkten in der Kodierperiode beschreibt und damit den Startzeitpunkt mit der zweiten Auflösung annähernd bestimmt und ein jeweiliges zweites Endphasenwort einen der N möglichen diskreten Zeitpunkte in der Kodierperiode beschreibt und damit den Endzeitpunkt mit der zweiten Auflösung annähernd bestimmt, und
- einen Ausgangssignalgenerator (130, 140, 150, 160; 200, 220), der ausgebildet ist, die Vielzahl zweiter Startphasenwörter (114.1...M) und die Vielzahl zweiter Endphasenwörter (116.1...M) in eine serielle Folge von Ausgangsimpulsen umzusetzen und als Ausgangssignal (162) über den Ausgang auszugeben, wobei die serielle Folge von Ausgangsimpulsen im zeitlichen Mittel dem Zielimpuls (108) entspricht.

2. Vorrichtung (1000) nach Anspruch 1, bei der dem Ausgangssignalgenerator (130, 140, 150, 160) ein Referenztaktsignal (132) zugeführt ist und der Ausgangssignalgenerator (130, 140, 150, 160) aufweist:
- einen Multiphasentaktsignalgenerator (130), der ausgebildet ist, aus dem Referenztaktsignal (132) ein Multiphasentaktsignal (134) abzuleiten, das eine Vielzahl um diskrete Phasenbeträge phasenverschobener Taktsignale aufweist, deren Phasenverschiebung gegenüber dem Referenztaktsignal sich beginnend mit Null von einem Taktsignal zum nächsten jeweils um einen Phasenabstand erhöht,
- einen Startphasenmultiplexer (140) und einen Endphasenmultiplexer (150), denen jeweils das Multiphasentaktsignal (134) eingangsseitig zugeführt ist, wobei
- der Startphasenmultiplexer (140) ausgebildet ist, in Abhängigkeit der Vielzahl zweiter Startphasenwörter (114.1...M) eines der phasenverschobenen Taktsignale als Startphasensignal (144) auf seinen Ausgang durchzuschalten und
- der Endphasenmultiplexer (150) ausgebildet ist, in Abhängigkeit der Vielzahl zweiter Endphasenwörter (116.1...M) eines der phasenverschobenen Taktsignale als Endphasensignal (156) auf seinen Ausgang durchzuschalten, und
- einen Signalkombinierer (160), der ausgebildet ist, das Startphasensignal (144) und das Endphasensignal (156) zum digitalen Ausgangssignal (162) zusammenzuführen, indem
- das Startphasensignal (144) die steigende Flanke eines jeweiligen Ausgangsimpulses im Ausgangssignal auslöst und das Endphasensignal (156) die fallende Flanke des jeweiligen Ausgangsimpulses auslöst.

3. Vorrichtung (2000) nach Anspruch 1, bei der der Ausgangssignalgenerator (200, 220) aufweist:
- einen Mapper (200), dem die Vielzahl zweiter Startphasenwörter (114.1...M) und die Vielzahl zweiter Endphasenwörter (116.1...M) zugeführt sind und der ausgebildet ist, in Abhängigkeit der Vielzahl zweiter Startphasenwörter (114.1...M) und der Vielzahl zweiter Endphasenwörter (116.1...M) eine Vielzahl Mapperausgangssignale (210) bereitzustellen, wobei
- ein jeweiliges der Mapperausgangssignale (210) einen Impuls bildet, dessen Pulsweite und Phase durch ein jeweiliges Wortpaar, welches aus einem jeweiligen der Vielzahl zweiter Startphasenwörter (114.1...M) und einem entsprechenden jeweiligen der Vielzahl zweiter Endphasenwörter (116.1...M) gebildet ist, bestimmt werden, und
- einen Ausgangsmultiplexer (220), der ausgebildet ist, die Vielzahl Mapperausgangssignale in das digitale Ausgangssignal umzusetzen.

4. Vorrichtung (1000; 2000) nach einem der vorstehenden Ansprüche, bei der der Phasenkodierer (100) bei einer Phasenkodierertaktrate und/oder der Phaseninterpolator (110) bei einer Phaseninterpolatortaktrate betrieben sind/ist und der Ausgangssignalgenerator bei einer Ausgangssignalgeneratortaktrate, wobei die Phasenkodierertaktrate und die Phaseninterpolatortaktrate jeweils wenigstens um den Faktor zwei geringer sind, als die Ausgangssignalgeneratortaktrate.

5. Vorrichtung (1000; 2000) nach einem der vorstehenden Ansprüche, bei der Phasenkodierer (100) ausgebildet ist, das erste Startphasenwort (104) und das erste Endphasenwort (106) derart abzuleiten, dass der Zeitpunkt der steigenden Flanke eines jeweiligen Ausgangsimpulses und der Zeitpunkt der fallenden Flanke des jeweiligen Ausgangsimpulses symmetrisch in Bezug auf eine Bezugsphase variiert sind.

6. Vorrichtung (1000; 2000) nach einem der vorstehenden Ansprüche, bei der der Ausgangssignalgenerator (160, 130, 140, 150; 200, 210) ausgebildet ist, im digitalen Ausgangssignal (162)
- einen Ausgangsimpuls mit zulässiger minimaler Pulsweite (169) zu erzeugen und sodann ein Entstehen eines nachfolgenden Ausgangsimpulses zu unterdrücken oder
- ein Entstehen eines Ausgangsimpulses zu unterdrücken und sodann einen Ausgangsimpuls mit zulässiger minimaler Pulsweite (169) zu erzeugen,
falls die Pulsweite des Zielimpulses (169) ein unzulässiges Minimum unterschreitet.

7. Vorrichtung (1000; 2000) nach einem der vorstehenden Ansprüche, wobei das Eingangssignal (102) ein Amplitudensignal (102.1) und ein Phasensignal (102.2) umfasst.

8. Vorrichtung (1000; 2000) nach einem der vorstehenden Ansprüche, bei der der Phaseninterpolator (110) zum Umwandeln wenigstens einen Delta-Sigma-Modulator umfasst.

9. Leistungsverstärker (170) mit einer Vorrichtung (1000; 2000) nach einem der Ansprüche 1 bis 8.

10. Sendeanordnung (190) mit einer Vorrichtung (1000; 2000) nach einem der Ansprüche 1 bis 9.

11. Verfahren zum Kodieren eines Eingangssignals (102) in ein digitales pulsweiten- und/oder phasenmoduliertes Ausgangssignal (162), im Folgenden als digitales Ausgangssignal (162) bezeichnet, mit den Schritten:
- Empfangen des Eingangssignals,
- Ableiten eines binären ersten Startphasenwortes (104) und eines binären ersten Endphasenwortes (106) aus dem Eingangssignal mit einer ersten Auflösung, wobei
- das erste Startphasenwort (104) einen Startzeitpunkt innerhalb einer Kodierperiode bestimmt, zu dem eine steigende Flanke eines Zielimpulses (108) im digitalen Ausgangssignal (162) auftreten soll, und das erste Endphasenwort (106) einen Endzeitpunkt innerhalb der Kodierperiode bestimmt, zu dem eine fallende Flanke des Zielimpulses (108) im digitalen Ausgangssignal (162) auftreten soll,
- Umwandeln des ersten Startphasenwortes (104) in eine Vielzahl zweiter binärer Startphasenwörter (114.1...M) und des ersten Endphasenwortes (106) in eine Vielzahl zweiter binärer Endphasenwörter (116.1...M) mit einer zweiten Auflösung, die kleiner als die erste Auflösung ist, wobei
- ein jeweiliges zweites Startphasenwort einen von N möglichen diskreten Zeitpunkten in der Kodierperiode beschreibt und damit den Startzeitpunkt mit der zweiten Auflösung annähernd bestimmt und ein jeweiliges zweites Endphasenwort einen der N möglichen diskreten Zeitpunkte in der Kodierperiode beschreibt und damit den Endzeitpunkt mit der zweiten Auflösung annähernd bestimmt,
- Umsetzen der Vielzahl zweiter Startphasenwörter (114.1...M) und der Vielzahl zweiter Endphasenwörter (116.1...M) in eine serielle Folge von Ausgangsimpulsen, wobei die serielle Folge von Ausgangsimpulsen im zeitlichen Mittel dem Zielimpuls (108) entspricht, und
- Ausgeben der seriellen Folge von Ausgangsimpulsen als digitales Ausgangssignal (162).

12. Verfahren nach Anspruch 11, bei dem das Umsetzen umfasst:
- Bereitstellen eines Referenztaktsignals (132),
- Ableiten eines Multiphasentaktsignals (134) aus dem Referenztaktsignal (132), wobei das Multiphasentaktsignal (134) eine Vielzahl um diskrete Phasenbeträge phasenverschobener Taktsignale aufweist, deren Phasenverschiebung gegenüber dem Referenztaktsignal sich beginnend mit Null von einem Taktsignal zum nächsten jeweils um einen Phasenabstand erhöht,
- Auswählen eines ersten der Vielzahl Taktsignale (134) in Abhängigkeit der Vielzahl zweiter Startphasenwörter (114.1...M) und Bereitstellen des ausgewählten ersten Taktsignals als Startphasensignal (144),
- Auswählen eines zweiten der Vielzahl Taktsignale (134) in Abhängigkeit der Vielzahl zweiter Endphasenwörter (116.1...M) und Bereitstellen des ausgewählten zweiten Taktsignals als Endphasensignal (156),
- Zusammenführen des Startphasensignals (144) und des Endphasensignals (156) zum Ausgangssignal (162), indem die das Startphasensignal (144) die steigende Flanke eines jeweiligen Ausgangsimpulses im digitalen Ausgangssignal (162) auslöst und das Endphasensignal (156) die fallende Flanke des jeweiligen Ausgangsimpulses auslöst.

13. Verfahren nach Anspruch 11, bei dem das Umsetzen umfasst:
- Erzeugen einer Vielzahl Mapperausgangssignale (210) in Abhängigkeit der Vielzahl zweiter Startphasenwörter (114.1...M) und der Vielzahl zweiter Endphasenwörter (116.1...M) mittels eines Mappers (200), wobei
- ein jeweiliges der Mapperausgangssignale (210) einen Impuls bildet, dessen Pulsweite und Phase durch ein jeweiliges Wortpaar, welches aus einem jeweiligen der Vielzahl zweiter Startphasenwörter (114.1...M) und einem entsprechenden jeweiligen der Vielzahl zweiter Endphasenwörter (116.1...M) gebildet ist, bestimmt werden, und
- serielles Ausgeben der Vielzahl Mapperausgangssignale (210) als das digitale Ausgangssignal (162).

14. Verfahren zum Senden eines hochfrequenten Ausgangssignals, bei dem ein niederfrequentes Eingangssignal (102) mit einem Verfahren nach einem der Ansprüche 11 bis 13 in das hochfrequente digitale pulsweiten- und/oder phasenmodulierte Ausgangssignal (162) transformiert wird und danach gesendet wird.
